(19) Europäisches Patentamt
European Patent Office
Office européen des brevets

(11) EP 1 731 299 A1

(12) EUROPEAN PATENT APPLICATION
published in accordance with Art. 158(3) EPC

(43) Date of publication:
**13.12.2006 Bulletin 2006/50**

(21) Application number: **05726733.8**

(22) Date of filing: **16.03.2005**

(51) Int Cl.:
***B32B 7/02*** (2006.01) ***C08J 7/06*** (2006.01)
***G09F 9/30*** (2006.01) ***H05B 33/02*** (2006.01)
***H05B 33/04*** (2006.01) ***H05B 33/14*** (2006.01)
*C23C 16/40* (2006.01) *C23C 16/42* (2006.01)

(86) International application number:
**PCT/JP2005/004680**

(87) International publication number:
**WO 2005/097484 (20.10.2005 Gazette 2005/42)**

(84) Designated Contracting States:
**AT BE BG CH CY CZ DE DK EE ES FI FR GB GR HU IE IS IT LI LT LU MC NL PL PT RO SE SI SK TR**

(30) Priority: **31.03.2004 JP 2004103244**

(71) Applicant: **KONICA MINOLTA HOLDINGS, INC.**
**Tokyo 100-0005 (JP)**

(72) Inventors:
- **OKUBO, Yasushi c/o Konica Minolta Technology 1928505 (JP)**
- **KITA, Hiroshi c/o Konica Minolta Technology Tokyo 1928505 (JP)**

(74) Representative: **Gille Hrabal Struck Neidlein Prop Roos**
**Patentanwälte**
**Brucknerstrasse 20**
**40593 Düsseldorf (DE)**

# (54) TRANSPARENT CONDUCTIVE FILM, METHOD FOR PRODUCING TRANSPARENT CONDUCTIVE FILM AND ORGANIC ELECTROLUMINESCENT DEVICE

(57) A transparent conductive film comprising at least a transparent plastic film, a gas barrier layer and a transparent conductive layer is **characterized in that** the refractive index thereof is so regulated as to decrease continuously or stepwise from the side having the transparent conductive layer to the other side. Also disclosed are a method for producing such a film efficiently, and an organic EL device which is **characterized by** comprising an organic electroluminescent element-forming layer on such a transparent conductive film and having a high luminance (namely emission luminance).

EP 1 731 299 A1

## Description

### TECHNICAL FIELD

This invention relates to a transparent conductive film, a method for producing the transparent conductive film and an organic electroluminescent element.

### BACKGROUND OF THE INVENTION

Hitherto, a glass plate having a transparent conductive layer has been used for substrate of electronic displaying element such as a liquid crystal displaying element, an organic EL element, a plasma display, an electronic paper, an electronic optical element such as CCD and CMOS sensor or a solar cell substrate, since such the plate has high thermal stability, high transparence and low steam permeability. Recently, however, a plastic substrate which is high in the flexibility, difficult to be broken and light in the weight is required instead of glass which is easily broken and relatively heavy, accompanied with spreading of portable telephones and portable information terminals.

However, usually produced plastic plates are relatively high in permeability of moisture and oxygen and contains moisture interior thereof. For example, when such the paler is used in a display having an organic electroluminescent element, the moisture is gradually diffused into the element and causes a problem of lowering in the durability of the element by the diffused moisture.

Moreover, the plastic palate is difficultly applied to an element such as the organic electroluminescent element destroyable by the presence of moisture or oxygen since moisture and oxygen are permeable through the plastic substrate. It is posed as a problem that how to seal the portion of the electroluminescent elements so that the elements are not exposed to moisture or oxygen.

It has been known to provide a layer capable of inhibiting permeation of various kinds of gas (a gas barrier layer) for inhibiting the permeation of the moisture or oxygen. As such the layer, a layer of silicon oxide, silicon nitride, silicon oxynitride, silicon carbide, aluminum oxide, aluminum oxynitride, titanium oxide, zirconium oxide, tin oxide, boron nitride and diamond-like carbon are known. Furthermore, a multilayered gas barrier composed of a layer of the above inorganic substance having high gas barrier ability and a soft thin organic layer has been known, cf. Patent Document 1, for example. However, the inorganic layer such as the transparent conductive layer and the gas barrier layer are formed on the substrate into a thickness of from several tens to several hundreds nanometer standing on the balance of the facts that the thicker layer is higher in the gas barrier ability and is lower in the anti-cracking ability. It has been known that the gas barrier layer or the interface thereof causes light interference since the thickness thereof is near the wavelength of light. Particularly, a problem is posed in the organic EL element that light reflection at the interface causes lowering in the output efficiency of light to the front face of the display because the difference in the refractive indexes between the ITO (indium tin oxide) of the transparent conductive layer, the support of the glass or plastic and the silicon oxide most frequently used as the barrier layer.

As the plastic film in which the light interference caused by the inorganic layer having a thickness of order of nanometer is inhibited, a gas barrier layer optically designed so the gas barrier layer also functions as an anti-reflection layer, cf. Patent Documents 2 and 3, for example.

However, it is a problem that the displays described in the above Patent Documents are designed so as that the reflection of exterior light is prevented, and high efficiency of taking out of the light emitted from the interior of the display cannot be raised.

A producing method of the gas barrier layer by a oxide thin layer of plural kinds of metal by CVD method, cf. Patent Document 4 for example, and an anti-reflection layer in which the ratio of $SiO_2$ to $TiO_2$ is varied according to the layer thickness direction by continuously varying the mixing ration of the supplied gases in CVD method is disclosed, cf. Patent Document 5 for example. However, problems are caused that the transparency of thus obtained gas barrier layer is insufficient from the viewpoint of practical use and the product efficiency is low because the process of forming the gas barrier layer of the anti-reflection layer is entirely carried out in vacuum or reduced pressure environment.

Patent Document 1: WO00/36665
Patent Document 2: Japanese Patent Publication Open to Public Inspection (hereafter referred to as JP-A) No. 5-299519
Patent Document 3: JP-A No. 2002-40205
Patent Document 4: JP-A No. 11-198281
Patent Document 5: JP-A No. 2000-192246

### SUMMARY OF THE INVENTION

An object of the invention is to obtain a transparent film having high gas barrier ability to moisture and oxygen (also described as low gas permeable), to provide a transparent conductive film having high gas barrier ability by a

method with high production efficiency without using any high cost and complex vacuum process and to provide an organic EL element emitting light with high luminance (or high luminance light).

One of the embodiments of the invention is a transparent conductive film having a transparent plastic film, a as barrier layer and a transparent conductive layer in which the refractive index is controlled so that the refractive index is continuously or stepwise reduced along the direction of from the surface having the transparent conductive layer to the other surface.

## BRIEF DESCRIPTION OF THE DRAWINGS

Fig. 1 shows a schematic drawing of an example of a plasma discharge treating chamber.
Fig. 2 shows a schematic drawing of an example of a roller electrode.
Fig. 3 shows a schematic drawing of oblique view of a fixed electrode.
Fig. 4 shows a schematic drawing of the plasma discharge treating chamber in which square-shaped fixed electrodes are provided around the roller electrode.
Fig. 5 shows a schematic drawing of a plasma layer-forming apparatus having the plasma discharge treating chamber.
Fig. 6 shows a schematic drawing of another example of the plasma layer-forming apparatus.
Fig. 7 shows a cross section of a prepared organic EL element.
Fig. 8 shows relations of the ratio of elements and the refractive index in the thickness direction of the gas barrier layer of a transparent conductive film 10.

## BEST MODES TO CARRY OUT THE INVENTION

In the invention, a transparent conductive film superior in the moisture barrier ability can be obtained by taking the constitution described in any one of the foregoing (1) to (8).

The film can be produced by the producing method described in any one of the foregoing (9) to (12). Moreover, an organic electroluminescent element, herein after also referred to as an organic EL element, emitting high luminance light can be provided by the constitution described in the foregoing (13).

The constituting elements relating to the invention is successively described below.

<<Transparent conductive film>>

The transparent conductive film of the invention is described below.

The transparent conductive film of the invention is characterized in that the film has at least a transparent plastic film, a gas barrier layer and a transparent conductive layer and the refractive index thereof is controlled so that the refractive index continuously or stepwise decreases along the direction from the surface of the transparent conductive film having the transparent conductive layer to the other surface of the transparent conductive film.

Here, the fact that "the refractive index continuously or stepwise decreases along the direction of from the surface having the transparent conductive layer to the other surface" will be described below.

A transparent film is considered in which the gas barrier layer is provided on the transparent plastic film and the transparent conductive layer is provided on the gas barrier layer.

In the above transparent conductive layer, the surface of one side may be a surface of the transparent plastic film on which no gas barrier layer is provided or the outermost surface of the transparent conductive layer.

When the variation of refractive index in the thickness direction of the transparent conductive film from the surface having the transparent conductive layer to the other surface is analyzed (or determined), the variation of the refractive index is analyzed in the thickness direction in the order of the transparent conductive layer → gas barrier layer → transparent plastic film.

When the refractive index is measured as above along the thickness direction, it is understood that the refractive index at the measuring point is controlled so that the refractive index continuously or stepwise decreases from the surface having the transparent conductive layer to the other surface.

When the gas barrier layer or the transparent conductive layer is constituted with plural layers, the refractive indexes of layers of the gas barrier layer and those of the layers of the transparent conductive layer may be the same of different from each other. However, it is understood that the refractive index is controlled so that the refractive index continuously or stepwise decreases when the variation of refractive index in the transparent conductive film is entirely analyzed (or measured) from the surface having the transparent conductive layer to the other surface.

<<Transmittance (or transparency) of transparent conductive layer>>

In the invention, the term of "transparent" is defined by that the transmittance of a plastic sample is not less than 70% at 650 nm when the measurement is carried out according to JIS R 1635 using spectral photometer U-4000 manufactured by Hitachi Seisaksho Co., Ltd. The transmittance of not less than 80% is preferable.

<<Measurement of refractive index of layer constituting transparent conductive film>>

The measurement of the refractive index of each of the transparent plastic film, gas barrier layer and transparent conductive layer constituting the transparent conductive film of the invention is described below.

The refractive index of each of the constituting layers can be measured by an apparatus available on the market such as an Abbe's refractometer and an ellipsometer M-44 manufactured by J. A. Woollam Co., Ltd.

When the measurement of the refractive index is not easy in the case of that the constituting layer such as the gas barrier layer is constituted by plural layers, the following method for measuring the refractive index is included in the invention; the elements constituting the constitution layer are measured by XPS (X-ray photoelectron spectroscopic analysis method) along the thickness direction and the refractive index at the measuring point is determined using a calibration curve preliminary prepared by the refractive indexes of layers each having various ratios of constituting elements.

<<Analysis of composition of constituting layer by XPS>>

The elements constituting the constituting layer of the electroconductive film of the invention can be analyzed by an XPS (X-ray photoelectron spectroscopy) surface analyzing apparatus. In the invention, an X-ray photoelectron spectroscopic surface analyzing apparatus ESCALAB-200R manufactured by VG Scientifix Co., Ltd. was uses. For the gas barrier layer constituted by plural layers in which the refractive index thereof was difficultly measured, the composition analysis of the elements of the constituting layer by the XPS was preferably applied. In such the case, the target was selected from the composition of the elements of each of the layers such as C, O, Si, and Ti and the refractive index at the measuring point was calculated by the content of each of the elements.

For conversing the element ratio to the refractive index, a calibration curve was used which is previously prepared by forming layers each different in the element ratio and measuring refractive index each of thus prepared layers.

The measurement was carried out by an X-ray of 600W (acceleration voltage: 15 kV, emission current: 40 mA) using an X-ray anode of Mg. The energy resolution was set at 1.5 eV to 1.7 eV by a half width value of the peak of cleared Ag3d5/2.

A surface layer corresponding to 10 to 20% of the thickness of the thin layer should be removed before the measurement for avoiding the influence of contamination. For removing the surface layer, an ion gun capable of using a rare gas ion was preferably applied. As the ion species, He, Ne, Ar, Xe and Kr were usable. In the measurement, the surface layer was removed by Ar ion etching.

First, the kind of detectable element was searched by measuring in the range of bonding energy of from 0 eV to 1,100 eV by a signal input interval of 1.0 eV.

Next, slow scanning was performed for detecting photoelectron peaks giving the maximum intensity by a signal input interval of 0.2 eV about entire elements other than the ion used for the etching for measuring spectra of each of the elements.

The obtained spectra were transferred to Common Data Processing Process (Preferably after Ver. 2.3) manufactured by VAMAS-SCA-Japan and processed by the same soft wear for canceling the difference in the content ratio calculation results caused by difference of the measuring apparatus, or computer. Thus the content of each of the target elements such as carbon, oxygen, silicon and titanium was obtained in the atomic concentration (at-%).

Count scale calibration was applied for each of the elements before the determination treatment and the results were subjected to 5-point smoothing. The peak area intensity (esp*eV) after removing the background was used for determination treatment. The method by Shirley was applied for treatment of back group. D. A. Shirley, Phys. Rev.., B5, 4709 (1972) can be referred about the method of Shirley.

(Refractive index of layer constituting the transparent conductive layer)

The transparent conductive film of the invention has the constitution in which at least one gas barrier layer is provided on the transparent plastic film having relatively low refractive index and the transparent conductive layer having relatively high refractive index is provided on the gas barrier layer as later-mentioned. As later-mentioned, the gas barrier layer may be constituted by single layer of plural layers and is provided between the transparent conductive layer and the transparent plastic film. The refractive index of the materials constituting the transparent plastic and the films are,

for example, 1.49 of PMA, 1.65 of PES (polyethersulfone), 1.60 of PET (polyethylene phthalate), 1.59 of polycarbonate, 1.51 of cycloolefin polymer, 1.48 of TAC (teriacetyl cellulose) and 1.30 of Teflon®.

The refractive index of the material for constituting the transparent conductive layer is, for example, 2.05 of ITO.

The above constituting materials of the transparent plastic and those of the transparent conductive layer have each an inherent refractive index.

The transparent conductive film is constituted by combining those materials. It has been found by the inventors that the reflection at the interface of two layers tends to occur and the transmittance of the transparent conductive film is lowered when two materials largely differ in the refractive index from each other are piled among the above combination. In concrete, it has been found that the transmittance of incident light from the transparent conductive layer side of the transparent conductive film to the medium having higher refractive index is lowered when the transparent conductive film is used in the organic EL element of the invention.

The inventors of this invention have succeeded to develop the transparent conductive film having high transmittance and low permeability of gas such as steam or oxygen by providing the gas barrier layer between the transparent conductive layer and the transparent plastic film so that the refractive indexes satisfies the relationship of: refractive index in the transparent conductive layer ≥ refractive index in the gas barrier layer ≥ refractive index in the transparent plastic film (provided that the refractive indexes are controlled so as to be the refractive index of transparent conductive layer > refractive index of transparent plastic film).

Provided that an embodiment in which the transparent conductive layer is provided on one surface and the gas barrier layer is provided on the other surface of the transparent plastic film is included in the transparent conductive film of the invention as long as the condition that the refractive index continuously or stepwise decreases or increases from one surface to the other surface is satisfies.

In such the case, the relation of the refractive indexes of each of the layers constituting the transparent conductive film is as follows.

The refractive indexes satisfy the relation of: transparent conductive layer ≥ transparent plastic film ≥ gas barrier layer (provided that the refractive indexes are controlled so as to be the refractive index of transparent conductive layer > refractive index of transparent plastic film).

The transparent conductive film of the invention has both of high light transmittance and high gas barrier ability. Therefore, it can be applied to various optical materials, and particularly suitable for the use as the substrate plate of the organic EL element, which is easily deteriorated by gas such as moisture and oxygen and requires high light transmittance.

The constitution of the organic EL element of the invention is describe later, and the reason of that the transparent conductive film of the invention is suitably used for the organic EL element will now be described.

In the organic EL element of the invention, the light source is placed at a position extremely near the transparent conductive film; therefore, different from a light source positioned at infinity, majority of the emitted light enters into the transparent conductive film at an oblique angle, not at right angle. When the difference in the refractive angle at the interface is large or the refractive index of the medium of light ejecting side is larger than that of the medium of light injecting side, the critical angle of total reflection becomes larger. As a result, the majority of light emitted from the organic EL element cannot be ejected from the front surface of the transparent conductive film and is guided to the end of the transparent conductive film and ejected from there so that the luminance of light emitted from the organic EL element is remained at low level.

As a result of the investigation by the inventors, it is found that the taking out efficiency of light can be considerably raised by providing a gas barrier layer between the transparent conductive layer having high refractive index and the plastic film, and between air and the plastic film when the refractive index of the gas barrier layer has a refractive index being middle of them. Thus an organic EL element emitting high luminance light can be obtained.

The gas barrier layer may be constituted by stepwise piling plural layers each different in the refractive index or single layer in which the refractive index is continuously varied by the continuously varying the composition of the layer.

<<Gas barrier layer>>

The gas barrier layer relating to the invention is described below.

The gas barrier layer relating to the invention is preferably formed by a spattering method, a coating method, an ion assist method, the later-mentioned plasma CVD method or the later-mentioned plasma CVD method performed under atmospheric pressure or near atmospheric pressure, and the plasma CVD method and the plasma CVD method performed under atmospheric pressure or near atmospheric pressure is more preferable and the plasma CVD method performed under atmospheric pressure or near atmospheric pressure is particularly preferable. Detail of the layer forming conditions by the plasma CVD method is mentioned later.

A material having desired refractive index can be selected from many kinds of materials for the plasma CVD method or the plasma CVD method performed under atmospheric pressure or near atmospheric pressure because a

metal carbide, metal nitride, metal oxide, metal sulfide, metal halide and their mixture such as metal oxide-nitride, metal oxide-halide, and metal nitride-carbide can be optionally produced by such the method by selecting organic metal compound as the raw material, gas for decomposition, decomposing temperature and applying electric power. The refractive index can be exactly controlled by mixing such the materials in a designated ratio.

For example, silicon oxide is formed by using a silicon compound as the raw material and oxygen as the decomposition gas, and zinc sulfide is formed by using a zinc compound as the raw material and carbon disulfide as the decomposition gas. In the space of the plasma, very high active charged particles or active radicals are exist in high density. Therefore, plural steps of chemical reaction are accelerated in very high rate in the plasma space and the elements being in the plasma space is converted to the chemically stable compound within extremely short duration.

The state of the inorganic raw material may be gas, liquid or solid at room temperature. The gas can be directly introduced into the discharging space and the liquid or solid is used after vaporized by a method such as heating bubbling and ultrasonic wave. The raw material may be used after diluted by a solvent. An organic solvent such as methanol, ethanol, n-hexane and a mixture thereof can be used for such the solvent. The influence of the solvent can be almost ignored because the solvent is decomposed into molecular or atomic state by the plasma discharge treatment.

However, the compound is preferably one having vapor pressure at a temperature within the range of from 0 to 250 °C at atmospheric pressure and more preferably one being liquid state at a temperature within the range of from 0 to 250 °C. The compound hardly vaporized under atmospheric pressure is difficult to be injected into the plasma layer forming chamber in gas state since the pressure in the plasma layer forming chamber is near the atmospheric pressure, and the amount of the compound to be charged in the gas plasma layer forming chamber can be precisely controlled. When the heat-resistive temperature of the plastic film on which the gas barrier layer is formed is not more than 270 °C, the compound is preferably one having vapor pressured at a temperature lower by 20 °C or more than the heat-resistive temperature.

Examples of such the organic compound include a silicon compound such as silane, tetramethoxysilane, tetraethoxysilane, tetra-n-propoxysilane, tetra-iso-propoxsilane, tetra-n-butoxysilane, tetra-t-butoxysilane, dimethyldimethoxysilane, dimethyldiethoxysilane, diethyldimethoxysilane, diphenylsimethoxysilane, methyltriethoxysilane, ethyltrimethoxysilane, phenyltriethoxysilane, (3,3,3-trifluoropropyl)trimethoxysilane, hexamethyldisyloxane, bis(dimethylamino)dimethylsilane, bis(dimethylamino)methylvinylsilane, bis(ethylamino)dimethylsilane, N,O-bis(trimethylsilyl)acetoamide, bis(trimethylsilyl)carbodiimide, diethylaminotrimethylsilane, dimethylaminodimethylsilane, hexamethyldisilazane, heaxamethylcyclotrisilazane, heptamethylsilazane, nonamethyltrisilazane, octamethylcyclotetrasilazane, tetrakisdimethyarninosilazane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiine,di-t-butylsilane, 1,3-disilabutane, bis(trimethylsilyl)methane, cyclopentanedienyltrimethylsilane, phenyldimethylsilane, phenyltrimethylsilane, propagyltrimethylsilane, tetramethylsilane, trimethylsilylacetylene, 1-(trimethyl-silyl)-1-propine, tris(trimehtylsilyl)methane, tris(trimethylsilyl)silane, vinyltrimethylsilane, hexamethyldisilane, octamethylcyclotetrasiloxane, tetramethylcyclotetrasiloxane, heaxmethylcycrotetrasiloxane and M-silicate 51.

Examples of the titanium compound include titanium methoxide, titanium ethoxide, titanium isopropoxide, titanium tetraisoboroxide, titanium n-butoxide, titanium isopropoxide(bis-2,4-pentanedionate), titanium diisopropoxide(bis-2,4-ethylacetoacetate), titanium di-n-butoxide(bis-2,4-pentanedionate), titanium caetylacetonate and butyl titanate dimer.

Examples of the zirconium compound include zirconium n-propoxide, zirconium n-butoxide, zirconium t-butoxide, zirconium tri-n-butoxide acetylacetonate, zirconium di-n-butoxide bisacetylacetonate, zirconium acetylacetonate, zirconium acetate and zirconium heaxafluoropentanedionate.

Examples of the aluminum compound include aluminum ethoxide, aluminum triisopropoxise, aluminum isopropoxide, aluminum n-butoxide, aluminum s-butoxide, aluminum t-butoxide, aluminum acetylacetonate and triethyldialuminum tri-s-butoxide.

Examples of the boron compound include diborane, boron fluoride, boron chloride, boron bromide, boranediethyl ether complex, borane-THF complex, borane-dimethyl sulfide complex, borane trifluoride-diethyl ether complex, triethylborane, trimethoxyborane, triethoxyborane, tri(isopropoxy)borane, borazole, trimethylborazole, triethylborazole and triisopropylborazole.

Examples of the tin compound include teraethyltin, tetramethyltin, diaceto-di-n-butyltin, terabutyltin, tetraoctyltin, tetraethoxytin, methyltriethoxytin, diethyldiethoxytin, triisopropylethoxytin, diethyltin, dimethyltin, diisopropyltin, dibutyltin, diethoxytin, dimethoxtin, diisopropoxytin, dibutoxytin, tin dibutylate, tin acetoacetonate, ethyltin acetoacetonate, ethoxytin acetoacetonate, dimethyltin acetoacetonate, tin hydride and tin halide such as tin dichloride and tin tetrachloride.

Examples of another organic metal compound include antimony ethoxide, arsenic triethoxide, barium 2,2,6,6-tetramethylheptanedionate, beryllium acetylacetonate, bismuth hexafluoropnetanedionate, dimethylcadmium, calcium 2,2,6,6-tetramethylheptanedionate, chromium trifluoropentanedionate, cobalt cetylacetonate, copper hexafluoropentanedionate, magnesium heaxfluoropentane-dionate-dimethyl ether complex, gallium ethoxide, tetraethoxygermanium, hafnium t-butoxide, hafnium ethoxide, indium acetylacetonate, indium 2,6-dimethylamino-heptanedionate, ferrocene,

lanthanum isopropoxide, lead acetate, tetraethyllead, neodium acetylacetonate, platinum hexafluoropentanedionate, trimethylcyclopentanedienyl-platinum, rhodium dicarbonylacetylacetonate, strontium 2,2,6,6-tetramethylheptanedionate, tantalum methoxide, tantalum trifluoroethoxide, tellurium ethoxide, tungsten ethoxide, vanadium triisopropoxideoxide, magnesium hexafluorocetylacetonate, zinc acetylacetonate and diethylzinc.

Examples of the decomposition gas for decomposing the raw material gas containing the metal to form an inorganic compound include hydrogen gas, methane gas, acetylene gas, carbon monoxide gas, carbon dioxide gas, nitrogen gas, ammonium gas, nitrogen suboxide gas, nitrogen oxide gas, nitrogen dioxide gas, oxygen gas, steam, fluorine gas, hydrogen fluoride, trifluoroalcohol, trifluorotoluene, hydrogen sulfide, sulfur dioxide, carbon disulfide and chlorine gas.

Various kinds of metal carbide, metal nitride, metal oxide, metal halide and metal sulfide can be obtained by suitably selecting the metal element-containing raw material gas and the decomposition gas.

The refractive index of the gas barrier layer obtained by using the above-mentioned raw materials is, for example, 1.67 of an aluminum oxide layer, 1.46 of a silicon oxide layer and 1.38 of a magnesium fluoride layer.

It is preferable that the gas barrier layer relating to the invention has high light transparence and high gas barrier ability when the layer is built-in the transparent conductive film of the invention. As a means for forming the gas barrier having both of the high light transmittance and high gas barrier ability, a method is applicable in which the composition in the layer is varied, and it is particularly preferable to contain at least two kinds of metal element in the layer. The two kinds of the metal are each preferably derived from the above-described organic metal compounds.

When the layer composed of a mixture of inorganic substances is formed for obtaining the gas barrier layer having the intended refractive index, two ways can be considered in one of which the mixing ratio of two or more kinds of raw material gas each containing a metal element is varied and in the other of which the mixing ratio of two or more kinds of the decomposition gas is varied, and the method to vary the mixing-ratio of the metal elements is advantageous since the refractive index can be largely varied. Mixing of two or more kinds of the decomposition gas is not preferably because reaction between the decomposition gases is cased sometimes, for example, water is formed from hydrogen gas and oxygen gas.

Such the reactive gase is mixed with a discharging gas capable of easily becoming into a plasma state and sent into the plasma discharge generation apparatus. As the discharging gas, a gas is preferable which easily causes discharge when an electric field is applied, and only induces a chain reaction and not form reaction product of itself even when the gas takes an excited state and des not remain in the formed layer. Nitrogen gas and/or an atom of Group 18 of periodic table such as helium, neon, argon, krypton, xenon and radon are used for such the discharging gas. Among them, nitrogen, helium and argon are preferably used. Helium is preferable since discharge beginning voltage in it is low and argon is preferable since it is lowest in the cost and is abundantly existence among the rare gases. Nitrogen is preferable since it is low in the cost and high in the layer forming rate even though it remains in the layer as contamination sometimes.

The inactive gas and the reactive gas are mixed to prepare a mixed gas and supplied into the plasma discharge (plasma generating) apparatus to form the layer. The reactive gas is supplied in a ratio of the inactive gas to whole mixture of the gases of 90.0 to 99.9% even though the ratio is varied depending on the properties of the layer to be formed.

The thickness of the gas barrier layer relating to the invention can be controlled by increasing the time for the plasma treatment, repeating the treatment or raising the partial pressure of the raw material compound.

The refractive index and layer thickness relating the preferable optical design of the layer constituting the organic EL element for obtaining the organic EL element of the invention emitting high luminance light is described below.

The gas barrier layer formed by stepwise piling layers each having the same refractive index.

When the gas barrier layers each having the same refractive index is piled by a certain thickness, and the refractive index of the gas barrier layer is $n_b$, one material contacting with one side of the gas barrier layer is $n_1$ and the refractive index of the material contacting with another side of the gas barrier layer is $n_2$, it is preferable that the intensity of beams of reflected light by the upper surface and lower surface is equal for completely canceling the light beams by themselves.

For controlling the intensity of such the two light beams to be the same, it is preferable that the following expression 1 is satisfied so that the ratios of the refractive indexes at both of the interfaces become the same.

Expression 1

$$n_1/n_b = n_b/n_2$$

Namely, it is preferable that the expression of $n_b = (n_1 \times n_2)^{1/2}$ is satisfied.

Moreover, for reducing the reflectivity and raising the light transmittance even when the gas barrier layer is provided, it is preferable that the wavelength $\lambda$ of the transmitting light (light of 550 nm is used for measuring the

transmittance in the invention) and the thickness of the gas barrier layer (optical layer thickness $n_d$) satisfy the following Expression 2.

Expression 2

$$\text{Optical layer thickness } n_d = \lambda/4$$

For example, when the gas barrier layer is formed at the interface of ITO and PET film, the refractive indexes of ITO and PET are each 2.05 and 1.60, respectively. Therefore, the refractive index of the gas barrier layer is preferably 1.81.

When a green light emitting element is constituted on such the transparent conductive film and the wavelength of light emitted from the element is assumed to 550 nm, it is preferable to make the thickness of the layer to 76 nm.

According to the above expression, 1.81 x 76 = 550/4.

When the gas barrier layer is formed at the interface of PES (polyethersulfone) and air, the refractive index of the gas barrier layer is preferably 1.28 because the refractive indexes of the PES and air are each 1.65 and 1.00, respectively.

When a red light emitting element is constituted on such the transparent conductive film and the wavelength of light emitted from the red light emitting element is assumed to 615 nm, it is preferable to make the thickness of the layer to 120 nm (1.28 x 120 = 615/4).

However, the refractive index of the inorganic material is constant for each of the material. Accordingly, any material having desired refractive index frequently cannot be found. In such the case, it is considered to form the layer by mixing inorganic compounds each having certain refractive indexes. The method generally applied for forming the inorganic layer such as a vapor depositing, spattering and ion plating methods, includes a method in which two kinds of target of inorganic substance are simultaneously deposited and a method in which a mixture of the inorganic substances is used as the target.

However, the simultaneously depositing method using two kinds of the inorganic substances target causes a problem that the mixing ratio is locally varied when the layer is formed on large area of the film so that the refractive index tends to be made ununiform. When the method using previously mixed target is used, the technical difficulty for depositing in the designated ratio is vary high since the two kinds of inorganic substance are different in the vapor pressure.

Consequently, the use of a chemical vapor phase depositing method (CVD method), not a physical vapor phase depositing method (PVD method) is preferably used as the vapor depositing method capable of freely varying the composition of the deposited layer. Among them, a plasma CDV method (PECVD method) is preferably applied by which the layer can be formed on a low heat-resistive substrate such as the plastic substrate.

In the CVD method, a composite thin layer of plural inorganic substances can be formed because gases as the raw material of the inorganic substance can be mixed in an optional ratio. Moreover, the composition of the gas barrier layer can be continuously varied in the CVD method by continuously varying the supplying ratio of the plural gases in the course of formation of the layer. Therefore, the CVD method is preferred.

Next, the formation of the gases barrier layer in which the refractive index is continuously varied is described.

When and the refractive indexes of the support and the transparent conductive layer are continuously connected by the continuously varying the refractive index of the gas barrier layer, the optical interface between the transparent conductive layer and the gas barrier layer disappears so that the light emitted from the light source and reflected, guided and ejected from the end of the transparent conductive layer can be further reduced. Consequently, the light taking out efficiency of the organic EL element can be raised and the organic EL element emitting high luminance light can be obtained. Moreover, the power consumption can be lowered for emitting the same amount of light so that the power savable organic EL element can be obtained.

The gas barrier layer relating to the invention is preferably formed by the plasma CVD method or the plasma CVD method performed at atmospheric pressure or near atmospheric pressure.

<<Plasma CVD method>>

The plasma CVD method relating to the invention is described below.

The plasma CVD method is also called as plasma assisting chemical vapor deposition method or PECVD method, by which a layer of various inorganic substances having high covering and contact ability can be formed on any solid-shaped body without excessively rising the temperature of substrate.

The usual CVD method (chemical vapor deposition method) is a method in which the evaporated or sublimated organic metal compound is stuck onto the surface of the substrate at high temperature and thermally decomposed to form a thin layer of a thermally stable inorganic substance. Such the usual CVD method cannot be applied for layer

forming on the plastic substrate since a substrate temperature of not less than 500 °C.

In the plasma CVD method, a space in which gas being in the plasma state (a plasma space) is generated by applying in the space near the substrate and the evaporated or sublimated organic metal compound is introduced into the plasma space and decomposed and then blown onto the substrate to form the thin layer of the inorganic substance. In the plasma space, the gas is ionized into ions and electrons in a high ratio of several percent and the electron temperature is very high though the gas is held at low temperature. Accordingly, the organic metal compound of the raw material of the inorganic layer can be decomposed by contacting with the high temperature electrons and the low temperature ion radicals. Therefore, the temperature of the substrate on which the organic layer to be formed can be lowered and the layer can be sufficiently formed by this method.

However, the plasma CVD method requires a large equipment and complex operation and is low in the product efficiency for producing the film of large area because the layer is usually formed in a space reduced in the pressure of from about 0.101 kPa to 10.1 kPa since it is necessary to apply an electric field to the gas for ionizing the gas into the plasma state.

As a result of investigation by the inventors, it has been found that the plasma can be generated under atmospheric or near atmospheric pressure under a certain condition so that the plasma CVD method can be performed under atmospheric or near atmospheric pressured. Thus a means for attaining the foregoing object of the invention is found.

In the plasma CVD method under near atmospheric pressure, not only the pressure reducing is not necessary and higher production efficiency can be obtained but also the layer forming rate is higher since the density of the plasma is higher compared with the plasma CVD method under vacuum.

It is cleared that the plasma CVD method under near atmospheric pressure is superior to the plasma CVD method under vacuum.

Furthermore, a surprising effect is found that the gas barrier layer obtained by the plasma CVD method under atmospheric pressure is lower in the center line average surface roughness Ra than that of the layer formed by the plasma CVD method under the vacuum. Though the detail of such the effect is not cleared yet, it is speculated that the effect can be obtained by high energy is applied to high density of plasma so that the collision frequency of the particles grown in the gas phase is raised (the average free distance is shortened).

When the center-line average roughness of the gas barrier layer is low, for example, the transparent conductive layer having uniform thickness and low surface resistance can be obtained after the transparent conductive layer is provided on such the gas barrier layer. The interior uniformity and the optical property of the gas barrier layer can be also improved.

The plasma layer-forming apparatus by the plasma CVD method under the atmospheric pressure or near atmospheric pressure is described in detail below.

An example of plasma layer-forming apparatus to be used for forming the gas barrier layer in the transparent conductive film producing method of the invention is described below referring Figs. 1 to 6. In the drawings, F is a long film as the substrate.

In the invention, the discharge plasma treatment is preferably carried out under atmospheric pressure or near atmospheric pressure. The near atmospheric pressure is a pressure of from 20 kPa to 110 kPa and preferably from 93 kPa to 104 kPa.

Fig. 1 shows an example of plasma treatment chamber provided in the plasma layer-forming apparatus. In the plasma discharge treatment camber 10 of Fig. 1, the film-shaped substrate F is conveyed by rotation of a roller electrode 25 rotated in the conveying direction (clockwise in the drawing). Plural fixed electrodes 26 are each constituted by a cylinder and arranged so as to face to the roller electrode 25.

As the discharge container 11 constituting the plasma discharge treatment chamber 10, a treatment container made from Pyrex® glass is preferably employed, and a metal container can be used if it is isolated from the electrodes. For example, one constituted by a frame of aluminum of stainless steel put with polyimide resin interior thereof or one constituted by such the frame isolated by thermally spraying ceramic can be used.

The substrate F rounded on the roller electrode 25 is pressed by nipping rollers 15 and 16 and regulated by guide rollers 23 and 24 and conveyed into a discharge treatment space formed in a discharge container 11, and subjected to a plasma treatment. After that, the substrate F is conveyed to next process through a nipping roller 16 and a guide roller 27. In the invention, such the continuous processing can be made possible and high production efficiency can be obtained because the gas barrier layer can be formed under the pressure almost the same as the atmospheric pressure, not vacuum.

A partition plate 14 is arranged near the nipping rollers 15 and 16 for inhibiting penetration of air into the discharge container 11 accompanied with the substrate F. The penetration of air accompanied with the substrate F is preferably inhibit by not more than 1%, and more preferably not more than 0.1%, by volume of the total volume of the gas contained in the discharge chamber 11. Such the condition can be satisfied by the nipping rollers 15 and 16.

The mixed gas to be used for the plasma discharge treatment is introduced to the discharge container 11 from the gas supplying opening 12 and the ages after treatment is exhausted from the exhausting opening 15.

The roller electrode 25 is a grounding electrode and the plural fixing electrodes 26 are voltage applying electrode, the reactive gas is introduced between the electrodes and electric discharge is carried out through the electrodes to generate plasma state, and the long length-shaped substrate rounded on the roller electrode 25 is exposed to the reactive gas in the plasma state for forming a layer derived from the reactive gas on the film.

It is preferable to supply in relatively large electric power of high frequency wave between the electrodes for raising the gas barrier ability and the forming rate of the layer and controlling the carbon content therein into a designated ratio range by obtaining high density of the plasma. In concrete, voltage with a high frequency of from 10 kHz to 2,500 MHz is preferably supplied. Superimposing application of a voltage of a frequency of from 10 kHz to 1 MHz and that of a frequency of from 1 MHZ to 2,500 MHz is more preferable.

The lower limit of the power to be applied between the electrodes is preferably within the range of from 0.1 W/cm$^2$ to 50 W/cm$^2$ and more preferably not less than 0.5 W/cm$^2$. When the voltage of the frequency of from 10 kHz to 1 MHZ and that of the frequency of from 1 MHz to 2,500 MHz are superimposed, the voltage of the frequency of from 1 MHz to 2,500 MHz is preferably lower than that of the frequency of from 10 kHz to 1 MHz. The applying area (cm$^2$) of the electrode is an area where discharge is occurring.

The high frequency voltage to be applied between the electrodes may be intermittent pulse wave or sine wave, and the sine wave is preferable for increasing the layer forming rate.

The electrode is preferably one constituted by a metal stuff covered with a dielectric material. It is preferable to cover at least one and more preferably both of the electrodes. The dielectric material is preferably an inorganic substance having a relative dielectric constant of from 6 to 45.

The minimum distance between the solid dielectric material and the electrode in the case of providing the solid dielectric material on one of the electrodes 25 and 26 and the distance between the solid dielectric materials in the case of providing the solid dielectric material on both of the electrodes are either preferably from 0.3 mm to 20 mm and particularly preferably from 1 mm $\pm$ 0.5 mm for uniformly occurring discharge. The distance between the electrodes is decided considering the thickness of the dielectric material around the electrode and the value of the applying voltage.

When the substrate is exposed to the plasma while standing or conveying between the electrodes, the thickness of the dielectric material and the gap between the electrodes can be held constant so as to stabilize the state of discharging not only by making one of the electrodes to the conveying roller by which the substrate is conveyed while contacting this roller but also by making the surface roughness of the electrode $R_{max}$ (JIS B 0601) to not more than 10 $\mu$m by polishing the surface of the dielectric material. The durability of the electrode can be largely improved by covering by the non-porous and high precision dielectric material by which occurrence of distortion and cracks caused by thermal shrinkage and remaining stress is prevented.

It is necessary in the preparation of the electrode by covering the core material by the dielectric material to polish up the dielectric material and to reduce the difference between the metal core of the electrode and the dielectric material in the thermal expansion as small as possible. Therefore, it is preferable that an inorganic material in which the foam content is controlled so as to form a stress absorbing layer is lined on the surface of the core material. The material is preferably glass obtained by a melting method such as in enamel, and the suitable electrode with high density and without cracking can be obtained by making the foam content to 0 to 30% by volume in the lowermost layer contacting with the core material and to not more 5% by volume in the next layer.

In another method for covering the core material of the electrode by the dielectric material, the ceramics is finely melt-sprayed so as to make the porosity of not more than 10% by volume and the pores are sealed by an in organic material curable by sol-gel reaction. Thermal or UV curing is suitable for accelerating the sol-gel reaction. Moreover, the mineralization is further improved and a fine electrode without deterioration can be obtained by alternatively repeating the coating of a diluted sealing liquid and curing thereof.

Figs 2(a) and 2(b) show roller electrodes 25c and 25C as examples of the roller electrode 25. As shown in Fig. 2(a), the grounded roller electrode 25c is constituted by a combination of a metal electroconductive core material 25a and a ceramic covering dielectric material 25b prepared by melt-spraying the ceramics and sealing by an inorganic material. The roller electrode 25 is prepared so that the diameter thereof is made to 316 mm after covering with 1 mm of the ceramic covering dielectric material and grounded. As the material of the ceramics to be used for the melt-spraying, alumina and silicon nitride are preferable and alumina is more preferable since it can be easily processed.

The roller electrode may also be constituted by the combination of an electroconductive metal core material 25A and a lining dielectric material 25B which is formed by lining an inorganic material so as to cover the core such as the roller electrode 25C shown in Fig. 2(b). As the material for lining, a silicate type glass, borate type glass, phosphate type glass, germanate type glass, tellurite type glass, aluminate type glass and vanadate type glass are preferably usable, among them the borate type glass is more preferable since it can be easily processed.

As the material for the metal cores 25a and 25A, a metal such as silver, platinum, stainless steel, aluminum and iron is usable and stainless steel is preferable from the viewpoint of processing.

In the embodiment of the invention, a jacketed stainless steel roller having a cooling means by water is employed (not shown in the drawing).

The electrodes 25, 25c and 25C are rotationally driven around an axis 25d or 25D by a driving mechanism not shown in the drawing.

Fig. 3(a) shows a schematic oblique view of the fixed electrode 26. The fixed electrode may have a square pillar shape, not limited to cylinder shape such as the fixed electrode 36 shown in Fig. 3(b). The square pillar-shaped electrode is preferably used according to the property of the layer to be formed since the discharging area can be expanded by such the electrode.

Both of the fixed electrodes 26 and 36 have the same structure as the roller electrodes 25c and 25C. Namely, the hollow stainless steel pipes 26a and 26A are each covered by dielectric material 26b and 36b, respectively, the same as in the roller electrode 25 (25c and 25C) and the electrodes can be cooled by cooling water on the occasion of discharge. The dielectric material of 26b and 36b may be either the ceramic or lining treated dielectric material.

The fixed electrode is prepared so that the diameter thereof is 12 mm or 15 mm after covering by the dielectric material. The number of the electrodes is fourteen, for example, which are arranged along the circumstance of the roller electrode.

Fig. 4 shows the plasma discharging treatment chamber 30 in which the square pillar-shaped fixed electrodes 36 shown in Fig. 3(b) are arranged around the roller electrode 25. In Fig. 4, the same signs are attached to the parts the same as those in Fig. 1 for omitting the description about them.

Fig. 5 shows a plasma layer-forming apparatus 50 including the plasma discharge treatment chamber 30 shown in Fig. 4. In Fig. 5, a gas supplying apparatus 51, a power source 41 and an electrode cooling unit 55 are arranges additionally to the plasma discharge treatment chamber. The electrode cooling unit 55 is composed of a tank 57 containing a cooling medium and a pump 56. As the cooling medium, an insulating material such as distilled water and oil is used.

The gap between the electrodes in the plasma discharge chamber 30 shown in Figs. 4 and 5 is set about 1 mm, for example.

The roller electrode 25 and the fixed electrodes 36 are arranged at designated positions in the plasma discharge chamber 30 and the mixed gas prepared in the gas supplying apparatus 51 is supplied through gas supplying opening 52 while controlling the flowing rate so as to fill the discharge container 11 by the mixing gas to be used for plasma treatment and the excessive gas is removed through an exhausting opening.

Then the voltage is applied to the fixed electrodes 36 from the power source 41and the roller electrode 25 is grounded, thus plasma by discharging is generated. The substrate is supplied from a bulk roll of substrate FF through rollers 54, 54 and 54, and guided by a guide roller 24 so that the substrate is conveyed between the electrodes in the plasma discharge treatment chamber 30 while touching with the roller electrode 25 on the one side thereof. On this occasion, the surface of the substrate is treated by the plasma by discharging and then conveyed to next process through a guide roller 27. The substrate is subjected to the discharge treatment on only one side not touched with the roller electrode 25.

For inhibiting bad influence of high temperature on the occasion of discharge, the substrate is cooled by the electrode cooling unit 55 according to necessity so as to control the temperature of substrate to a temperature of from room temperature (15 to 25 °C) to less than 250 °C and more preferably from room temperature to 200 °C.

Fig. 6 shows an example of the plasma layer-forming apparatus to be used for a method for forming a constituting layer of the transparent conductive film. The plasma layer-forming apparatus 60 is an apparatus for forming a thin layer by jetting the reactive gas previously prepared in the plasma state onto the substrate when the substrate 61 has a shape difficultly set between the electrodes such as a thick-shaped substrate.

In Fig. 6, 35a is dielectric material, 35b is a metal core and 65 is a power source. Mixed gas composed of inactive gas and reactive gas is introduced to upper portion of a slit shaped discharging space formed by a metal core 35b covered with dielectric material 35a and made to plasma state by applying high frequency voltage generated by the power source 65, and the reactive gas in plasma state is jetted onto the substrate 61 to form a thin layer on the substrate 61.

Though the power source for the plasma layer-forming apparatus for forming the layer of the invention such as the power source 41 in Fig. 5 and that 65 in Fig. 6 is not specifically limited, a high frequency power source (15 kHZ) manufactured by Shinkou Denki Co., Ltd., a high frequency power source (50 kHZ) manufactured by Shinkou Denki Co., Ltd., a high frequency power source (100 kHZ in continuously using mode) manufactured by Haiden Kenkyusho Co., Ltd., a high frequency power source (200 kHZ) manufactured by Pearl Kogyo Co., Ltd., a high frequency power source (800 kHZ) manufactured by Pearl Kogyo Co., Ltd., a high frequency power source (2 MHZ) manufactured by Pearl Kogyo Co., Ltd., a high frequency power source (13.56 MHZ) manufactured by Pearl Kogyo Co., Ltd., a high frequency power source (27 MHZ) manufactured by Pearl Kogyo Co., Ltd., and a high frequency power source (150 MHZ) manufactured by Pearl Kogyo Co., Ltd., are usable. Moreover, power sources each oscillating 43 MHz, 800 MHz, 1.3 GHz, 1.5 GHz, 1.9 MHz, 2.4 MHz, 5.2 MHz and 10 GHz are applicable. It is preferable to overlap a power source of 10 kHz to 1 MHz and that of 1 MHz to 2,500 MHz.

The method for piling gas barrier layers different from each other in the mixing ratio of the metal elements includes a method in which a gas barrier layer having a composition is formed by conveying the substrate in the plasma discharge treatment chamber of Fig. 1 and winding up, and another layer is formed on the foregoing layer and such the

treatment is repeated by necessary times by changing each the condition of the plasma discharge treatment apparatus, and a method in which several plasma discharge treatment chambers shown in Fig. 1 are prepared and the substrate is conveyed so that the plural layers are formed one by one by passing through each of the apparatus, and a method in which the substrate, the head and the tail thereof are connected with together, is conveyed through plural plasma discharge treatment apparatuses and the layers are formed one by one by passing each of the apparatuses.

As the method for forming the gas barrier layer in which composition of plural metal elements is continuously varied along the thickness direction of the layer by the atmospheric pressure plasma CVD method, for example, a method is applicable in which the substrate, the head and the tail thereof are connected with together, is conveyed through the plasma discharge treatment chamber of Fig. 1 while the ratio of the organic metal compound gas supplying to the plasma discharge treatment chamber is continuously varied.

<<Transparent plastic film>>

The transparent plastic film relating to the invention is described below.

The transparent plastic film, also referred to as the transparent resin substrate, is not specifically limited as long as the film is substantially transparent. Concrete examples of the film include a film of a polyester such as poly (ethylene terephthalate) and poly(ethylene naphthalate), polyethylene, polypropylene, a cellulose ester and its derivative such as cellophane, cellulose diacetate, cellulose triacetate, cellulose acetate butylate, cellulose acetate propionate, cellulose acetate phthalate and cellulose nitrate, poly(vinylidene chloride), poly(vinyl alcohol), polyethylene vinyl alcohol, syndiotactic polystyrene, polycarbonate, norbonene resin, polymethylpentene, poly(ether ketone), polyimide, poly(ether sulfone), polysulfones, poly(ether ketoneimde), polyamide, fluororesin, nylon, poly(methylacrylate), polyacryls and polyallylates and an organic-inorganic hybrid resin formed by the above resin and silica.

(Transmittance)

The "substantially transparent" is defined by that the transmittance of a plastic sample is not less than 70% at 650 nm when the measurement is carried out according to JIS R 1635 by spectral photometer U-4000 manufactured by Hitachi Seisaksho Co., Ltd. In the invention, a transmittance of not less than 80% is preferable.

(Thermal resistivity)

The gas barrier is provided on the transparent plastic film relating to the invention and the atmospheric plasma CVD method is preferably applied for forming the gas barrier layer.

It is preferable that the transparent plastic film, on which the gas barrier layer is formed, has high thermal resistivity because the contamination by the carbon component derived from the organic metal compound is reduced accompanied with rising in the layer forming temperature and the plastic film is subjected sometimes to various processes at high temperature.

It is preferable to form the film using a resin having a Tg (glass transition point) of not less than 180 °C as a means for giving high thermal resistivity to the transparent plastic film.

(Glass transition point Tg of transparent plastic film)

As the resin material satisfying such the condition, certain kind of polycarbonate, certain kind of cycloolephin polymer, polyethersulfone, poly(ether ether ketone), polyimide, fluororesin, diacetyl cellulose, triacetyl cellulose and an organic-inorganic hybrid resin composed of the above resin and silica can be cited.

The glass transition point of the resin material can be measured by methods known in the technical field such as DSC (differential scanning calorimetry), TMA (thermal stress distortion measurement) and DMA (dynamic viscoelastic measurement).

Diacetyl cellulose, triacetyl cellulose and the organic-inorganic hybrid of them and silica are preferable which have high transmittance, low double refractivity and positive wavelength scattering ability of double refraction. It is preferable that the film contains the cellulose ester as the major component (the major component is a component accounting for 50% or more of the whole composition).

Examples of the cellulose ester include cellulose diacetate, cellulose acetate butylate, cellulose acetate propionate, cellulose acetate phthalate, cellulose triacetate and cellulose nitrate and a derivative thereof.

The organic-inorganic hybrid resin (also referred to as organic-inorganic polymer composite) is a material formed by combining an organic polymer and an inorganic substance for giving properties of both materials to the resin. Fine particles having a particle size smaller than the wavelength of visible light (less than approximately 750 nm) in nanoscale can be dispersed in the organic substance by a method so called sol-gel method in which an inorganic

substance in a liquid state such as a metal alkoxide is mixed with the organic polymer for synthesizing the objective polymer composite so that the material having high transparence and thermal resistivity can be obtained.

In the invention, a subbing layer may be provided on one or both sides of the transparent plastic film as an anti-plasma etching layer, a hard-coat layer or a stress alleviation layer because the surface of the transparent film is directly exposed to the plasma atmosphere when the gas barrier layer is formed by the plasma CVD method on the transparent plastic film. In concrete, an organic layer formed by coating a polymer can be used as the subbing layer. The organic layer includes, for example, a layer of an organic material having a polymerizable group subjected to a post treatment such as UV irradiation or heating. When such the layers are contained in the transparent conductive film of the invention, it is essential that the refractive index is continuously or stepwise increased or decreased along the direction of from one side to another side of the film.

<<Transparent conductive layer>>

The transparent conductive layer relating to the invention is described below.

The transparent conductive layer relating to the invention is an optically transparent and electroconductive layer.

Examples of typical transparent conductive layer relating to the invention include a thin layer of a metal, an oxide such as $SnO_2$, ZnO and $In_2O_3$, a composite oxide such as indium tin oxide (ITO), F-doped SnO (FTO), Al-doped ZnO (AZO) and In-doped ZnO (IZO) and an non-oxide compound such as a calcogenide and TiN. Among them, ITO is preferably used.

For forming the transparent conductive layer relating to the invention, a spattering method, a coating method, an ion assist method, a plasma CVD method and a plasma CVD method under atmosphere or near atmosphere pressure are applicable, and the conditions the same as those for forming the foregoing gas barrier layer are applied for forming the layer.

The "transparent" of the transparent conductive layer is defined by that the transmittance of a plastic sample is not less than 70% at 650 nm when the measurement is carried out according to JIS R 1635 by spectral photometer U-4000 manufactured by Hitachi Seisaksho Co., Ltd. In the invention, a transmittance of not less than 80% is preferable.

The "electroconductive" of the transparent conductive layer is defined by a relative resistance of the order of not more than $10^{-2}$ $\Omega$·cm measured by a four-terminal method according to JIS R 1637 using Rolesta GP MCP-T600 manufactured by Mitsubishi Kagaku Co., Ltd. In the invention, a resistance of the order of $10^{-4}$ $\Omega$·cm is preferable.

The organic electroluminescent element is described below.

The organic electroluminescent element (also referred to as organic EL element) has a structure in which a light emission layer is placed between a pair of electrodes of an anode and a cathode. The light emission layer in this specification is, in broad sense, a layer emitting light when an electric current is applied between the cathode and the anode. Concretely, the light emission layer is a layer containing an organic substance emitting light when an electric current is applied between the cathode and the anode. The organic EL element relating to the invention may have a positive hole injection layer, an electron injection layer, a positive hole transportation layer an electron transportation layer additionally to the light emission layer, which are placed between the cathode and the anode. Furthermore, the element may have a protective layer.

In concrete, the following structures can be taken.

(i) Anode/Light emission layer/Cathode
(ii) Anode/Positive hole injection layer/Light emission layer/Cathode
(iii) Anode/Light emission layer/Electron injection layer/Cathode
(iv) Anode/Positive hole injection layer/Light emission layer/Electron injection layer/Cathode
(v) Anode/Positive hole injection Layer/Positive hole transportation layer/Light emission layer/Electron transportation layer/Electron injection layer/Cathode

A cathode buffer layer such as a lithium fluoride layer may be inserted between the electron injection layer and the cathode. An anode buffer layer such as a copper phthalocyanine layer may be inserted between the anode and the positive hole injection layer.

The electron transportation layer is also called hole blocking layer and the hole blocking layer is preferably provided in the structure (v) particularly in an element so called a phosphorescent element in the light emission layer of which an ortho metal complex as a dopant. Examples of such the element are described in International Patent Publication Pamphlet No. 00/70656 and JP-A No. 2001-313178.

The positive hole injection layer, electron injection layer, positive hole transportation layer and electron transportation layer may be provided in the light emission layer itself. Namely, the light emission layer may have at least one of (1) an injection function capable of injecting the positive hole from the anode or the positive hole injection layer and injecting the electron from the cathode or the electron injection layer on the occasion of applying the electric field, (2) a

transportation function capable of moving the injected charge (the electron and the positive hole) by the force of the electric field, and (3) a light emission function capable of supplying a recombination site of the electron and the positive hole in the light emission layer so as to emit light. In such the case, separately provision of one or more of the positive hole injection layer, electron injection layer, positive hole transportation layer and electron transportation layer becomes unnecessary. Moreover, the positive hole injection layer, electron injection layer, positive hole transportation layer and electron transportation layer may be given a light emission function by adding the light emission compound into these layers. It is preferable that the light emission layer has a function of transporting at least one of charges though the easiness of injection of the positive hole and that of the electron may be different and the transportation ability or the mobility of the positive hole and that of the electron also may be different from each other.

As the light emission material to be used in the light emission layer, ones know as the light emitting material in organic EL elements can be used without any limitation. Such the light emission materials are mainly organic compounds and, for example, those described in Macromol. Symp., 125, pp. 17 to 26 are usable according to desired tone.

The light emission material may have the positive hole injection function and the electron injection function together with the light emission function, and almost positive hole injection materials and electron injection materials can be used for the light emission material.

The light emission material may be a polymer material such as p-polyphenylenevinylene and polyfluorene, and a polymer material prepared by introducing the light emission material into a polymer chain or that having the light emission material as the main chain may be used.

A dopant (a guest substance) may be used in combination in the light emission layer, and optionally selected one from known substances used for a dopant for EL elements can be used.

Concrete typical examples of the dopant include quinacridone, DCM, coumalin derivatives, rhodamine, rubrene, decacyclene, pyrazoline derivatives, squalilium derivatives and europium complexes. Indium complexes such as those described in JP-A No. 2001-247859, compounds represented by the formula described in WO 0070655, pp. 16 to 18 such as tris(2-phenylpyridine)iridium, osmium complexes and platinum complexes such as 2,3,7,8,12,13,17,,18-octaethyl-21H,23H-porphyline platinum complex can be cited as the dopant.

For producing the light emission layer using the above materials, the materials are made to a thin layer by known methods such as an evaporation deposition method, spin coat method, casting method, printing method, ink-jet method, spray method and LB method. The formed layer is preferably a molecular sedimentary layer. The molecular sedimentary layer is a thin layer formed by sedimentation from the compound in a gas state or that formed by solidifying the compound in a molten or liquid state. The molecular sedimentary layer is distinguished from the thin layer formed by the LB method (molecular accumulative layer) according to the difference in the cohering structure, high dimensional structure and in the functional property caused by the structure.

Moreover, the light emission layer can be formed by making a solution, which is prepared by dissolving the light emission material and a binder such as a resin by a solvent, to a thin layer by the spin coat method such as that described in JP-A No. 57-51781. The thickness of thus formed light emission layer is usually from 5 nm to 5 μm though the thickness is not specifically limited and optionally decided according to the situation.

The positive hole injection material using for the positive hole injection layer has one of positive hole injecting the positive hole and electron blocking ability, and may be either an organic or inorganic substance. Examples of the positive hale injection material include triazole derivatives, oxadiazole derivatives, imidazole derivatives, polyarylalkane derivatives, pyrazoline derivatives, pyrazolone derivatives, phnylenediamine derivatives, arylamine derivatives, amino-substituted calcone derivatives, oxazole derivatives, styrylanthrathene derivatives, fluolenone derivatives, hydrazone derivatives, stilbene derivatives, silazane derivatives, aniline polymers, electroconductive oligomers particularly thiophene oligomers. The above-described compounds can be used and porphylin compounds, aromatic tertiary amine compounds and styrylamine compounds are preferably used.

Typical examples of the aromatic tertiary amine compounds and styrylamine compounds include N,N,N',N'-tetraphenyl-4,4'-diamonophenyl, N,N'-diphenyl-N,N'-bis(3-methylphenyl)-[1,1'-biphenyl]-4,4'-diarnine (TPD), 2,2-bis(4-di-p-triamino-phenyl)propane, 1,1-bis(4-di-p-triaminophenyl)cyclohexane, N,N,N',N'-tetra-p-tolyl-4,4'-diaminobiphenyl, 1,1-bis(4-di-p-tolylaminophenyl)-4-phnylcyclohexane, bis(4-dimethylamino-2-methylphenyl)phenylmethane, bis(4-dip-tolylaminophenyl)phenylmethane, N,N'-diphenyl-N,N'-di(4-methoxyphenyl)-4,4'-diaminobiphenyl, N,N,N',N'-tetraphenyl-4,4'-diaminodiphenyl ether, 4,4'-bis(diphenlamino)biphenyl, N,N,N-tri(p-tolyl)amine, 4-(di-p-tolylamino)-4'-[4-(ditolylamino)styryl]stilbene, 4-N,N-diphenylamino-(2-dipnenylvinyl)benzene, 3-methoxy-4'-N,N-diphenylaminostyl-benzene, N-phenylcarbazole, compounds each having two condensed aromatic rings in the molecule thereof described in U. S. Patent No. 5,061,569 such as 4,4'-bis[N-(1-naphthyl)-N-phenyl]-biphenyl (NPD), and compounds in which triphenylamine units are linked into three starburst form such as 4,4',4"-tris[N-3-methylphenyl)-N-phenylamino]triphenylamine (MTDATA) described in JP-A No. 308688.

Moreover, inorganic compounds such as p-type Si, p-type SiC are also used as the positive hole injection material. The positive hole injection layer can be formed by making the above positive hole injection materials to thin layer by known methods such as an evaporation deposition method, spin coat method, casting method, printing method,

ink-jet method, spray method and LB method. The thickness of the positive hole injection layer is usually from 5 nm to 5 μm though the thickness is not specifically limited. The layer may have a single layer structure composed of one or more kinds of the above material or a multi-layer structure composed of plural layers having the same or different composition.

The electron injection layer has a function of transmitting electrons injected from the cathode to the light emission layer and the material therefore can be selected from the known compounds. Examples of the material to be used in the electron injection layer, hereinafter referred to as the electron injection material, include nitro-substituted fluorene derivatives, diphenyl quinoline derivatives, thiopyrazine oxide derivatives, heterocyclic teracarboxylic acid anhydrides such as naphthaleneperylene, carbodimide, fuluorenylidenemethane derivatives, derivatives of anthraquiodimethane and anthrone, and oxadiazole derivatives. Though a series of electron transmitting compounds is disclosed in JP-A No. 59-194393 as a material for constituting the light emitting layer, it is cleared by investigation by the inventors that the compounds can be used for the electron injection material. Moreover, the above thiazole derivatives in which the oxygen atom of the diazole ring is replaced by a sulfur atom and quinoxaline derivatives having a quinoxaline ring known as an electron attractive group can be also applied for the electron injection material. Furthermore, metal complexes of 8-quinolinol derivative such as tris(8-quinolinol)aluminum (Alq), tris(5,7-dichloro-8-quinolinol)aluminum, tris(5,7-dibromo-8-quinolinol)-aluminum, tris(20methyl-8-quinolinol)aluminum, tris(5-methyl-8-quinolinol)aluminum, bis(8-quinolinol)zinc (Znq) and the above complexes in each of which the central metal is replaced by In, Mg, Cu, Ca, Sn, Ga or Pb are also preferably applied for the electron injection material. Other than those, metal free or metal phthalocyanine and that substituted by an alkyl group or a sulfonic acid group at the terminal thereof are preferably used as the electron injection material. The distyrylpirazine derivatives exemplified as the material of the light emission layer can also be applied for the electron injection material, and inorganic semiconductors such as n-type Si and n-type SiC can be used as the electron injection material.

The electron injection layer can be formed by making the above compound to a thin layer by, for example, a vacuum deposition method, spin coat method, casting method or LB method. The thickness of the electron injection layer is usually from 5 nm to 5 μm though the thickness is not specifically limited. The layer may have a single layer structure composed of one or more kinds of the above material or a multi-layer structure composed of plural layers having the same or different compositions.

A buffer layer (an electrode interface layer) may be provided between the anode and light emission layer or the positive hole injection layer, and between the cathode 4 and the light emission layer or the electron injection layer.

The buffer layer is a layer provided between the electrode and the organic layer for lowering the driving voltage and rising the light emission efficiency, which is described in detail in "Organic EL element and Front of Its Industrialization" NTS Co., Ltd., 30th November 1998, Part 2, Section 2, "Electrode Material"" pp. 123 to 166. An anode buffer layer and a cathode buffer layer are employed.

The anode buffer layer is described in detail in JP-A Nos. 9-45479, 9-260062 and 8-288069, and concrete examples thereof include a phthalocyanine buffer layer typified by copper phthalocyanine, an oxide buffer layer typified by vanadium oxide, an amorphous carbon buffer layer, a polymer buffer layer using an electroconductive polymer such as polyaniline (emeraldine) and polythiophene.

The cathode buffer layer is also described in detail in JP-A Nos. 6-325871, 9-17574 and 10-74586, and concretely a metal buffer layer typified by strontium or aluminum, an alkali metal compound buffer layer typified by lithium fluoride, an alkali-earth metal compound buffer layer typified by magnesium fluoride and an oxide buffer layer typified by aluminum oxide are applied.

The buffer layer is preferably a very thin layer and the layer thickness of it is preferably from 0.1 to 100 nm even though the thickness is varied according to the material.

Furthermore, a layer having another function may be provided additionally to the above basic layer structure, for example, the layer may have a positive hole blocking function described in JP-A Nos. 11-204258 and 11-204359 and "Organic EL element and Front of Its Industrialization" NTS Co., Ltd., 30th November 1998, p. 237.

At least one of the anode buffer layer and the cathode buffer layer may contain at least one of the compounds of the invention ao as to function as the light emission layer.

The electrode made from a metal, an alloy, an electroconductive compound or a mixture thereof each having high work function (not less than 4 eV) as the electrode material is preferable. Concrete examples of the electrode material include a metals such as Au, and an electroconductive transparent material such as CuI, iridium tin oxide (ITO), $SnO_2$ and ZnO.

The anode is prepared by formation of the thin layer of the electrode material and a method such evaporation depositing method and spattering method, and photolithographic method may be applied for forming a desired pattern. When excessive high precision is not required (about 100 μm or more), the pattern may be formed by using a mask of the desired pattern on the occasion of the evaporation deposition or the spattering. When emitting light is taken out from the anode, the transmittance is desirably made to not less than 10% and the sheet resistivity of the anode is preferably not more than several hundreds ohm/sq. The layer thickness is usually from 10 nm to 1 μm and preferably from 10 nm

to 200 nm which may be varied according to the material.

As the cathode of the organic EL layer, one prepared by an electrode material (a metal referred to as an electron injection metal) having low work function (not more than 4eV), an alloy, an electroconductive compound and their mixture is used. Concrete examples of such the electrode material include sodium, sodium-potassium alloy, magnesium, lithium, magnesium-copper mixture, magnesium-silver mixture, magnesium-aluminum mixture, magnesium-indium mixture, aluminum-aluminum oxide ($Al_2O_3$) mixture, indium, lithium-aluminum mixture and a rare-earth metal. Among them, a mixture of the electron injective metal and a second metal having higher work function and more stable than the electron injective metal such as the magnesium-silver mixture, magnesium-aluminum mixture, magnesium-indium mixture, aluminum-aluminum oxide ($Al_2O_3$) mixture and lithium-aluminum mixture is suitable from the viewpoint of the electron injecting ability and the durability. The cathode can be prepared by making a thin layer by such the electrode material by the evaporation deposition method or the spattering method. The sheet resistance of the cathode is preferably not more than several hundreds ohm/sq and the layer thickness is usually decided within the range of from 10 nm to 1 $\mu$m and preferably from 50 to 200 nm. It is advantageous for improving in the light emission efficiency that at least one of the anode and the cathode of the organic EL element is transparent or translucent.

The organic EL element having organic EL element constituting layers on the transparent conductive film of the invention, for example, Anode/Positive injection layer/Light emission layer/Electron injection layer/Cathode, is described below referring Fig. 7.

Fig. 7 shows an example of the organic EL element of the invention using the transparent conductive film of the invention.

In Fig. 7, the organic EL element has the transparent conductive film 1 and a substrate 5 facing to the transparent conductive film which is constituted by transparent plastic film 100 and a clear hard-coat layer 102 and a gas barrier layer 101 provided on the plastic film and further has a transparent conductive layer 2.

The gas barrier layer 101 may be a single layer or a piled layer and the transparent conductive layer 2 is used for constituting the anode of the organic EL element of the invention.

The substrate 5 has a constitution the same as the transparent plastic film 100 except that the transparent conductive layer 2 is omitted.

The organic EL element constituting layers 3 is formed on the transparent conductive film 1, and layers (also referred to as thin layers) each containing the materials for constituting the organic EL element such as the positive hole injection layer, light emission layer and electron injection layer are formed on the transparent conductive layer, which are not shown in the drawing.

After that, the cathode 4 containing the foregoing material is formed by the method of evaporating deposition or spattering on the organic EL element constituting layer 3.

An optional method can be selected for forming the respective layers. As the method, the spin coat method, casting method, printing method, ink-jet method, spray method and evaporating deposition method are applicable. Among them, the vacuum deposition method is preferable by which a uniform layer can be easily obtained and a pinhole is difficultly formed. When the vacuum deposition method is applied, it is preferable to suitably select within the range of a boat heating temperature of from 50 °C to 450 °C, a vacuum degree of from $10^{-6}$ Pa to $10^{-3}$ Pa, an evaporation rate of from 0.01 nm/sec to 50 nm/sec, a substrate temperature of from -50 °C to 30 °C and a layer thickness of from 5 nm to 5 $\mu$m even though the conditions may be varied according to the kind of the compound to be used, the objective crystal structure and association structure of the molecular accumulated layer.

After the formation of these layers, a thin layer of cathode material such as aluminum is formed so that the layer thickness is made to not more than 1 $\mu$m, preferably from 20 nm to 200 nm by, for example, the method such as evaporating deposition or spattering to form the cathode. Thus desired organic EL element can be obtained.

It is preferable that the production of the organic EL element is continuously performed from the positive hole injection layer to the cathode in the same vacuum atmosphere, but the reversal processing order of the cathode, electron injection layer, light emission layer, positive hole injection layer and anode may be applied. Light emission can be observed by applying a voltage of from 3 V to 40 V using the anode for the positive pole and the cathode for the negative pole. No light emission occurs when the voltage is applied to the reversal poles. When an alternative voltage is applied, light is emitted only on the occasion of applying positive voltage to the anode and negative voltage to the cathode. The wave shape of the alternative voltage may be optional.

A protective layer may be provided on the whole surface of the organic EL element. The inorganic protective layer is constituted by, for example, $CeO_2$ in which $SiO_2$ is dispersed. The inorganic protective layer is formed by a method such as the spattering method, ion plating method and evaporating deposition method and the thickness is preferably from 0.1 nm to 10,000 nm and more preferably from 50 nm to 10,000 nm in usual.

The inorganic protective layer can be continuously formed in the vacuum after formation of the cathode without returning to the atmosphere or can be formed in vacuum after once conveying the element by a conveying system capable of conveying the element can be conveyed in nitrogen or inactive gas atmosphere.

It is preferable that the transparent plastic film on which the gas barrier layer of the invention is formed is piled

on the upper surface of the organic EL element and subjected to sealing treatment.

The sealing is carrier out by pasting the gas barrier layer of the substrate and that of the transparent conductive film 1 through a frame-shaped sealing material provided by a coating method or a transfer method at the circumference portion of the under side (the surface facing to the transparent conductive film 1) of the substrate 5 facing to the film. The sealing agent is composed of a thermal curable type epoxy resin, a UV curable type epoxy resin or a room temperature curable type epoxy resin capable of beginning reaction by pressing.

In such the case an opening, not shown in the drawing, for exhausting air is provided at a designated portion of the sealing material for completing the sealing. The opening for air exhausting is sealed in a reduced pressure atmosphere, preferably at a vacuum degree of not less than $1.33 \times 10^{-2}$ MPa, or nitrogen gas or inactive gas atmosphere using any one of the above epoxy resin or UV curable resin.

The epoxy resin to be used in such the case contains the followings as the principal agent: a resin of bisphenol A type, bisphenol F type, bisphenol AD type, bisphenol S type, xylenol type, phenolnovolac type, multifunctional type, tetraphenylol-methane type, poly(ethylene glycol) type, poly(propylene glycol) type, hexanediol type, trimethylolpropane type, propylene oxide-bisphenol A type and hydrogenised bisphenol A type and mixtures of them. When the sealing material 6 is provided by the transfer method, the sealing material made to a state of film.

The facing substrate 5 may be formed by glass, resin, ceramics, metal, a metal compound or a composite material of them. The substrate 5 desirably has a steam permeation rate according to JIS K 7129 of not more than 1 $g/m^2 \cdot 1$ atm·24 hr at 25 °C at a thickness of 1 μm. Such the material may be selected from the above materials.

In the invention, a water absorbable or water reactive material such as barium oxide can be sealed in the element in a form of a layer formed on the substrate.

In the organic EL element constituted as above-described, the transparent conductive film 1 and the substrate 5 facing to the film is pasted with together through the frame-shaped sealing material. Accordingly, the organic EL element and the cathode 4 provided on the transparent conductive film 1 can be sealed by the substrate 5 and the sealing material so that the element can be sealed at the low humidity state and permeation of water through the substrate can be prevented. Thus the moisture resistivity of the organic EL display can be further improved and occurrence and growing of dark spots can be further inhibited.

The foregoing constitution for describing the organic EL element of the invention is one of embodiments of the invention and the constitution of the organic EL element including the transparent conductive film is not limited to the above-described embodiment.

## EXAMPLES

The invention is concretely described below referring examples but the invention is not limited thereto.

Example 1

<<Preparation of transparent conductive film 1 (comparative example)>>

A $SiO_2$-$TiO_2$ composite layer was prepared by referring Sample No.8 of Example 1 in the foregoing Patent Document 4.

The following raw material gas A of $TiO_2$ and raw material gas A of $SiO_2$ were mixed in a ratio of 1 : 1. The resultant mixture was introduced in a rate of 10 sccm into a plasma space in which plasma was generated at a pressure of 53.3 Pa to form a $SiO_2$-$TiO_2$ composite layer of 85 nm on a diacetyl cellulose-silica hybrid film on which a clear hard-coat layer was formed. The output of the applied voltage was 4 $W/cm^2$ at 13.56 MHz, and the layer forming rate was adjusted to 0.25 nm/sec under the above conditions.

The $SiO_2$-$TiO_2$ composite layer had a refractive index of 1.77, a steam permeation rate of 5.9 $g/m^2/d$ and ax oxygen permeation rate 3.8 $ml/m^2/d$. The average surface roughness was 3.4 nm.

The transparent conductive layer (where an indium tin oxide (ITO) layer) was formed in a thickness of 100 nm on the surface opposite to the surface on which the $SiO_2$-$TiO_2$ composite layer was formed. Therefore, the layer constitution of the transparent conductive layer was as follows.

ITO layer (2.05)/Support (1.48)/Hard-coat layer (1.54)/$SiO_2$-$TiO_2$ layer (1.77)

In the above, data shown in the parenthesis is the refractive index.

The whole light transmittance of the accumulated film was 81%.

<<$TiO_2$ raw material gas A>>

| | |
|---|---|
| Discharge gas: argon | 16% by volume |
| Decomposition gas: oxygen | 83.0% by volume |
| Raw material gas: titanium tetraisopropoxide | 1.0% by volume |
| Evaporation temperature: | 60 °C |

<<$SiO_2$ raw material gas A>>

| | |
|---|---|
| Discharge gas: argon | 16% by volume |
| Decomposition gas: oxygen | 83.0% by volume |
| Raw material gas: heaxamethyldisiloxane | 1.0% by volume |
| Evaporation temperature: | 0 °C |

<<Preparation of transparent conductive film 2 (comparative example)>>

A ratio varying $SiO_2$-$TiO_2$ layer was prepared referring Example 1 in the foregoing Patent Document 5.

$TiO_2$ raw material gas B was heated by 90 °C and introduced into the plasma space generated under 1 atmosphere (133.3 Pa) in a rate of 3 slm and gradually replaced by $SiO_2$ raw material gas B and completely replaced by the $SiO_2$ raw material gas B in the final. Thus a ratio varying $TiO_2$-$SiO_2$ layer of 100 nm was formed on the diacetyl cellulose-silica hybrid film on which a clear-coat layer was previously formed. The output of the applied voltage was 10 W/cm$^2$ at 8 KHz. The layer forming rate under such the conditions was 2.1 nm/second.

The resultant film had a steam permeation rate of 280 g/m$^2$/d, an oxygen permeation rate of 440 ml/m$^2$/d and an average surface roughness of 2.5 nm.

A transparent conductive layer (ITO layer) of 100 nm was formed on the surface of the film opposite to the surface on which the $SiO_2$-$TiO_2$ composite layer.

The layer structure of thus obtained transparent conductive film 2 (comparative example) was as follows.

ITO layer (2.05)/Support (1.48)/Hard-coat layer (1.54)/$SiO_2$-$TiO_2$ inclined layer

The whole light transmittance of the accumulated film was 85%.

<<$TiO_2$ raw material gas B>>

| | |
|---|---|
| Discharge gas: argon | 99.5% by volume |
| Raw material gas: titanium tetraisopropoxide | 0.5% by volume |
| Evaporation temperature: | 60 °C |

<<$SiO_2$ raw material gas B>>

| | |
|---|---|
| Discharge gas: argon | 99.5% by volume |
| Raw material gas: tetraethoxysiloxane | 0.5% by volume |
| Evaporation temperature: | 30 °C |

<<Transparent conductive film 3 (inventive example)>>

The following $Al_2O_3$ raw material gas was heated by 120 °C and introduced into the plasma space generated under 1 atmosphere at a rate of 10 slm to form an $Al_2O_3$ layer of 90 nm on the diacetyl cellulose-silica hybrid film on which a hard-coat layer was previously formed. The output of the applied voltage was 10 W/cm$^2$ at 80 KHz and 5 W/cm$^2$ at 13.56 MHz. The layer forming rate under such the conditions was 4.1 nm/second.

The refractive index of the $Al_2O_3$ layer was 1.64. The resultant film had a steam permeation rate of 1.0 g/m$^2$/d, an oxygen permeation rate of 0.95 ml/m$^2$/d and a average surface roughness of 0.9 nm. A transparent conductive layer

of 100 nm was formed on the $Al_2O_3$ layer.

The layer constitution of thus obtained transparent conductive film 3 was as follows.

Support (1.48)/hard-coat layer (1.54)/$Al_2O_3$ layer (1.64)/ITO layer (2.05)

The whole light transmittance of the accumulated film was 90%.

<<$Al_2O_3$ raw material gas>>

| | |
|---|---|
| Discharge gas: nitrogen | 99.3% by volume |
| Decomposition gas: oxygen volume | 0.5% by |
| Raw material gas: triethyldialuminum tri-s-butoxide | 0.2% by volume |
| Evaporation temperature: | 100 °C |

<<Transparent conductive film 4 (inventive example)>>

The following $TiO_2$ raw material gas C and $SiO_2$ raw material gas C were mixed in a ratio of 1 : 1. The mixed gas was heated by 90 °C and introduced into the plasma space generated under 1 atmosphere in a rate of 10 slm to form a $SiO_2$-$TiO_2$ composite layer of 85 nm on the diacetyl cellulose-silica hybrid film on which a hard-coat layer was previously formed. The output of the applied voltage was 8 W/cm$^2$ at 100 KHz and 5 W/cm$^2$ at 13.56 MHz. The layer forming rate under such the conditions was 7.0 nm/second.

The refractive index of the $SiO_2$-$TiO_2$ composite layer was 1.77. The resultant film had a steam permeation rate of 0.93 g/m$^2$/d, an oxygen permeation rate of 0.80 ml/m$^2$/d.

The average surface roughness was 0.7 nm.

A transparent conductive layer (ITO layer) of 100 nm was formed on the $SiO_2$-$TiO_2$ composite layer. The layer constitution of thus obtained transparent conductive film 4 of the invention was as follows.

Support (1.48)/hard-coat layer (1.54)/ $SiO_2$-$TiO_2$ composite layer (1.77)/ITO layer (2.05)

The whole light transmittance of the accumulated film was 91%.

<<$SiO_2$ raw material gas C>>

| | |
|---|---|
| Discharge gas: nitrogen | 95.0% by volume |
| Decomposition gas: hydrogen | 4.8% by volume |
| Raw material gas: tetraethoxysilane | 0.2% by volume |
| Evaporation temperature: | 30 °C |

<<$TiO_2$ raw material gas C>>

| | |
|---|---|
| Discharge gas: nitrogen | 95.0% by volume |
| Decomposition gas: hydrogen | 4.8% by volume |
| Raw material gas: titanium tetraisopopoxide | 0.2% by volume |
| Evaporation temperature: | 60 °C |

<<Transparent conductive film 5 (inventive example)>>

The following $MgF_2$ raw material gas was heated at 90 °C and introduced into the plasma space generated under 1 atmosphere in a rate of 10 slm to form a $MgF_2$ layer of 100 nm was formed on the surface opposite to the transparent conductive film 4. The output of the applied voltage was 5 W/cm$^2$ at 13.56 MHz and 7 W/cm$^2$ at 40 kHz. The layer forming rate under such the conditions was 3.5 nm/second. The refractive index of the $MgF_2$ layer was 1.38.

The resultant accumulated film had a steam permeation rate of 0.34 g/m$^2$/d, an oxygen permeation rate of 0.25 ml/m$^2$/d.

The average surface roughness of the $MgF_2$ layer was 0.8 nm.

The transparent conductive layer was formed on the $TiO_2$-$SiO_2$ composite layer of a thickness of 100 nm.

The layer constitution of thus obtained transparent conductive film 5 of the invention was as follows.

$MgF_2$ layer (1.38)/Support (1.48)/hard-coat layer (1.54)/ $SiO_2$-$TiO_2$ composite layer (1.77)/ITO layer (2.05)

The whole light transmittance of the accumulated film was 92%.

<<$MgF_2$ raw material gas>>

| | |
|---|---|
| Discharge gas: nitrogen | 95.0% by volume |
| Decomposition gas: hydrogen | 4.8% by volume |
| Raw material gas: magnesium hexafluloroacetylacetonate dimethyl ether complex | 0.2% by volume |
| Evaporation temperature: | 70 °C |

<<Transparent conductive film 6 (inventive example)>>

The $TiO_2$ raw material gas and the $SiO_2$ raw material gas were mixed in a ratio of 15 : 85. The mixed gas was heated by 90 °C and introduced into the plasma space generated under 1 atmosphere in a rate of 10 slm to form a $SiO_2$-$TiO_2$ composite layer of 95 nm on the diacetyl cellulose-silica hybrid film on which a hard-coat layer was previously formed. The output of the applied voltage was 6 W/cm$^2$ at 100 KHz and 4 W/cm$^2$ at 13.56 MHz. The refractive index of the $SiO_2$-$TiO_2$ composite layer was 1.65. The layer forming rate under such the conditions was 11 nm/second.

An $SiO_2$-$TiO_2$ composite layer of 90 nm was further piled under the same conditions using a mixture of the $TiO_2$ raw material gas C and the $SiO_2$ raw material gas in a ratio of 33 : 67. The refractive index of thus formed $SiO_2$-$TiO_2$ composite layer was 1.65. The layer forming rate was 6.5 nm/second.

An $SiO_2$-$TiO_2$ composite layer of 85 nm was further piled under the same conditions using a mixture of the $TiO_2$ raw material gas C and the $SiO_2$ raw material gas in a ratio of 50 : 50. The refractive index of thus formed $SiO_2$-$TiO_2$ composite layer was 1.76. The layer forming rate was 6.9 nm/second.

An $SiO_2$-$TiO_2$ composite layer of 80 nm was further formed under the same conditions using a mixture of the $TiO_2$ raw material gas C and the $SiO_2$ raw material gas in a ratio of 67 : 33. The refractive index of thus formed $SiO_2$-$TiO_2$ composite layer was 1.85. The layer forming rate was 7.2 nm/second.

An $SiO_2$-$TiO_2$ composite layer of 75 nm was further piled under the same conditions using a mixture of the $TiO_2$ raw material gas C and the $SiO_2$ raw material gas in a ratio of 17 : 83. The refractive index of thus formed $SiO_2$-$TiO_2$ composite layer was 1.95. The layer forming rate was 7.3 nm/second.

After that, a $TiO_2$ layer of 70 nm was further filed under the same conditions using the $TiO_2$ raw material gas C. The refractive index of thus formed $TiO_2$ layer was 2.05. The layer forming rate was 7.3 nm/second.

The film after forming these $SiO_2$-$TiO_2$ composite layers had a steam permeation rate of 0.22 g/m$^2$/d, an oxygen permeation rate of 0.21 ml/m$^2$/d. The roughness of the outermost surface was 0.8 nm.

A transparent conductive layer was formed on the $SiO_2$-$TiO_2$ composite layer. The layer constitution of thus obtained transparent conductive film 6 of the invention was as follows.

Support (1.48)/Hard-coat layer (1.54)/$SiO_2$-$TiO_2$ composite layer 1 (1.55)/ $SiO_2$-$TiO_2$ composite layer 2 (1.65) /$SiO_2$-$TiO_2$ composite layer 3 (1.76)/$SiO_2$-$TiO_2$ composite layer 4 (1.85)/ / $SiO_2$-$TiO_2$ composite layer 5 (1.95)/$TiO_2$ layer (2.05) /ITO layer (2.05)

The whole light transmittance of the accumulated film was 92%.

<<Transparent conductive film 7 (inventive example)>>

After the formation of the $SiO_2$-$TiO_2$ composite layer the same as in the transparent conductive layer 6, a Teflon® layer of 115 nm was formed on the opposite side of the film by introducing the following Teflon® raw material gas into the plasma space generated under 1 atmosphere. The output of the applied voltage was 1 W/cm$^2$ at 13.56 MHz. The layer forming rate under such the conditions was 5.5 nm/second.

The refractive index of the Teflon® layer was 1.30. The film had a steam permeation rate of 0.17 g/m$^2$/d, an oxygen permeation rate of 0.21 ml/m$^2$/d. The average surface roughness of the Teflon® layer was 0.4 nm.

The transparent conductive layer was formed on the $SiO_2$-$TiO_2$ composite layer. The constitution of thus obtained transparent conductive film 7 was as follows.

Teflon® layer (1.30)/Support (1.48)/ Hard-coat layer (1.54)/ / $SiO_2$-$TiO_2$ composite layer 1 (1.55)/ $SiO_2$-$TiO_2$ composite layer 2 (1.65)/$SiO_2$-$TiO_2$ composite layer 3 (1.76)/$SiO_2$-$TiO_2$ composite layer 4 (1.85)/$SiO_2$-$TiO_2$ composite

layer 5 (1.95)/$TiO_2$ layer (2.05)/ITO layer (2.05)

The whole light transmittance of the accumulated film was 93%.

<<Teflon® raw material gas>>

| | |
|---|---|
| Discharge gas: argon | 99.8% by volume |
| Raw material gas: tetrafluoroethylene (gas) | 0.2% by volume |
| Gas temperature: | 30 °C |

<<Transparent conductive film 8 (inventive example)>>

In the atmospheric pressure plasma CVD layer forming apparatus, a $SiO_2$-$TiO_2$ inclined in the composition was formed by rolling the acetyl cellulose-silica hybrid film in looped shape.

The $TiO_2$ raw material gas and the $SiO_2$ raw material gas were mixed in a ratio of 15 : 85. The mixed gas was heated by 90 °C and introduced in a rate of 10 slm into the plasma space generated under the atmospheric pressure and then the ratio of the $TiO_2$ raw material gas was gradually increased in proportional to time so that the ratio finally become 100 : 0 to for a gas barrier layer of 265 nm. The output of the applied voltage was 8 W/cm$^2$ at 100 kHz and 5 W/cm$^2$ at 13.56 MHz. The layer forming rate under such the conditions was 7.0 nm/second.

Variation ratio of the elements along the depth direction of the $SiO_2$-$TiO_2$ composite layer is shown in Fig. 8. The ratio of the elements was measured by XPS while etching the surface by Ar plasma by 40 nm by 40 nm. The refractive indexes at the measuring points were each calculated by a calibration curve showing the relation of the element ratio and the refractive index. Calculated results are listed in Table 1.

Table 1

| depth | C | O | Si | Ti | Refractive index |
|---|---|---|---|---|---|
| 0 | 1.8 | 68.1 | 0.2 | 29.9 | 2.05 |
| 40 | 1.5 | 67.9 | 5.4 | 25.2 | 1.95 |
| 80 | 1.3 | 67.3 | 10.1 | 21.3 | 1.85 |
| 120 | 1.1 | 67 | 14.7 | 17.2 | 1.78 |
| 160 | 0.9 | 67.3 | 19.4 | 12.4 | 1.69 |
| 200 | 0.7 | 66.6 | 23.8 | 8.9 | 1.63 |
| 240 | 0.5 | 66.3 | 29.1 | 4.1 | 1.54 |

The element ratio was measured at the surfaces formed by etching by Ar plasma 40 nm by 40 nm using an X-ray photoelectronic spectrometry (XPS) apparatus Escalab-200R, manufactured by VG Scientific Co., Ltd., available on the market. Thus formed gas barrier layer had a steam permeation rate of 0.14 g/m$^2$/d and an oxygen permeation rate of 0.11 ml/m$^2$/d. The average roughness of the surface was 0.9 nm.

The transparent conductive layer (ITO layer) was formed on the $TiO_2$-$SiO_2$ composite layer. The layer constitution of thus obtained transparent conductive film 8 of the invention was as follows.

Support (1.48)/Hard-coat layer (1.54)/$SiO_2$-$TiO_2$ composite layer (1.55 to 2.05)/ITO layer (2.05)

The whole light transmittance of the accumulated film was 93%.

<<Transparent conductive film 9 (inventive example)>>

An $SiO_2$ layer of 95 nm was formed on the surface of the transparent conductive film 8 opposite to the surface on which the $SiO_2$-$TiO_2$ composite layer was formed by introducing the $SiO_2$ raw material gas in a rate of 10 slm into the plasma generated under 1 atmosphere. The output of the applied voltage was 5 W/cm$^2$ at 13.56 MHz and 8 W/cm$^2$ at 100 kHz. The layer forming rate under such the conditions was 5.5 nm/second. The refractive index of this $SiO_2$ layer was 1.46.

On the $SiO_2$ layer, a $MgF_2$ layer of 100 nm was formed by introducing the $MgF_2$ raw material gas in a rate of 10 slm into the plasma space generated under 1 atmosphere. The output of the applied voltage was 5 W/cm$^2$ at 13.56

MHz and 7 W/cm$^2$ at 40 kHz. The layer forming rate under such the conditions was 3.5 nm/second. The refractive index of this $MgF_2$ layer was 1.38.

After that, a Teflon® layer of 105 nm was formed on the $MgF_2$ layer by introducing the Teflon® raw material gas in a rate of 10 slm into the plasma space generated under 1 atmosphere. The output of the applied voltage was 1 W/cm$^2$ at 13.56 MHz. The layer forming rate under such the conditions was 5.5 nm/second. The refractive index of this $MgF_2$ layer was 1.30.

The obtained accumulated film had a steam permeation rate of 0.1 g/m$^2$/d and an oxygen permeation rate of 0.1 ml/m$^2$/d. The average surface roughness of the Teflon® layer was 0.5 nm.

The transparent conductive layer was formed on the $TiO_2$-$SiO_2$ composite layer. The layer constitution of thus obtained transparent conductive film 8 was as follows.

Teflon® layer (1.30)/$MgF_2$ layer (1.38)/$SiO_2$ layer (1.46)/Support (1.48)/Hard-coat layer (1.54)/$SiO_2$-$TiO_2$ composite layer (1.55 to 2.05)/ITO layer (2.05)

The whole light transmittance of the accumulated film was 94%.

<<Evaluation of transparent conductive>>

The methods for evaluating the light transmittance and the gas barrier ability (steam permeation rate and oxygen permeation rate) applied for the transparent conductive films 1 to 9 are described in detail below.

<<Transmittance (also referred to as light transmittance)>>

The transmittance at 550 nm of each of the transparent conductive films 1 to 9 was measured by a spectrophotometer U-4000 manufactured by Hitachi Seisakusho Co., Ltd., according to JIS R 1635.

<<Gas barrier ability>>

For evaluating the gas barrier ability, the steam permeation rate and the oxygen permeation rate of each of the transparent conductive layers 1 to 9 before the provision of the ITO layer were measured.

Thus obtained results are listed in Table 2.

Table 2

| Transparent conductive film No. | Variation of refractive index *1 | Transmittance (%) *2 | Gas barrier ability *3 | | Remarks |
|---|---|---|---|---|---|
| | | | Steam permeation rate g/m$^2$/d | Oxygen permeation rate ml/m$^2$/d | |
| 1 | Yes | 81 | 5.9 | 3.8 | Comp. |
| 2 | Yes | 85 | 280 | 440 | Comp. |
| 3 | No | 90 | 1.0 | 0.95 | Inv. |
| 4 | No | 91 | 0.93 | 0.80 | Inv. |
| 5 | No | 92 | 0.34 | 0.25 | Inv. |
| 6 | No | 93 | 0.22 | 0.21 | Inv. |
| 7 | No | 93 | 0.17 | 0.21 | Inv. |
| 8 | No | 93 | 0.14 | 0.11 | Inv. |
| 9 | No | 94 | <0.1 | <0.1 | Inv. |

*1: The refractive index is continuously or stepwise reduced or not along the direction from the surface having the transparent conductive layer to the other surface Yes: The refractive index is continuously or stepwise reduced No: The refractive index is reduced not continuously nor stepwise
*2: Light transmittance after formation of ITO layer
*3: Gas barrier ability before formation of ITO layer Comp.: Comparative, Inv.: Inventive

It is understood from Table 2 that the transparent conductive films 3 to 9 are higher in the transmittance and in the gas barrier ability compared with comparative samples and has the properties suitable for various optical apparatuses.

<<Preparation of organic EL element OLED 1-1>>

An α-NPD layer (a thickness of 25 nm), a co-deposited layer (a thickness of 35 nm) of CBP and Ir (ppy) formed by a evaporating deposition method in a evaporation rate ratio of 100:6, a BC layer (a thickness 10 nm), an $Alq_3$ layer (a thickness of 40 nm) and a lithium fluoride layer (a thickness of 0.5 nm) were successively formed through a square mask with a hole by the vacuum evaporating deposition method on the transparent conductive layer of the transparent conductive film 1 as the organic EL layer 3 in Fig. 7, each of the above layers are not shown in Fig. 7. Furthermore, the cathode E of aluminum having a thickness of 100 nm was formed through another mask having a different pattern.

CBP

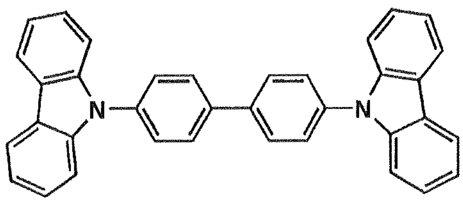

BC

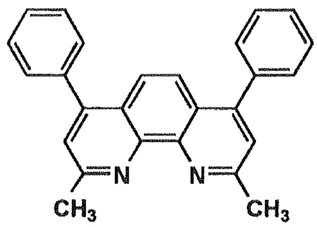

$Alq_3$

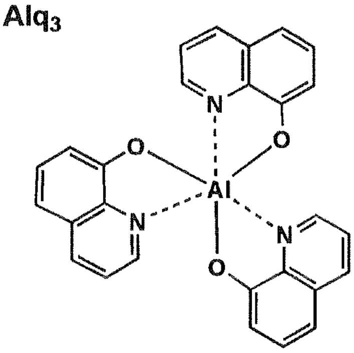

α −NPD

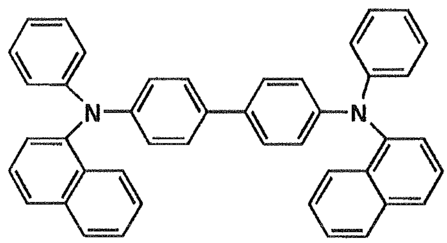

$Ir(ppy)_3$

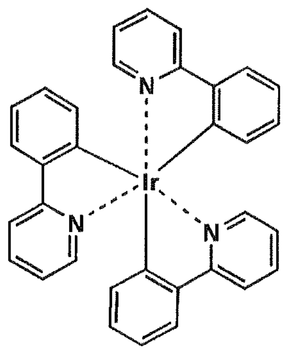

<<Sealing treatment>>

Film the same as the transparent conductive film 1 except that the ITO layer was omitted is applied as the substrate 5 in Fig. 7 to thus obtained accumulated product and contacted so as to face to the gas barrier layer side of the film and the circumstance of it was sealed by a photocurable adhesive Luxtrack LC0629B manufactured by Toagosei Co., Ltd. Thus organic EL element LED 1-1 was obtained.

The transparent electrode and the aluminum cathode are each contacted to an terminal.

<<Preparation of organic E1 elements OELD 1-2 to 1-9>>

Organic EL elements 1-2 to 1-11 were each prepared in the same manner as in the organic EL element 1-1 except that the transparent conductive films 1-2 to 1-9 were used, respectively.

<<Evaluation>>

The luminance of each of the organic EL elements 1-1 to 1-9 was measured when a direct voltage of 10 V was applied to the light emission portion.

Thus obtained results are shown below.

| Organic EL element No. | Luminance |
|---|---|
| 1 | 7,000 cd/$m^2$ |
| 2 | 7,000 cd/$m^2$ |
| 3 | 10,000 cd/$m^2$ |
| 4 | 11,000 cd/$m^2$ |
| 5 | 12,000 cd/$m^2$ |
| 6 | 12,000 cd/$m^2$ |
| 7 | 13,000 cd/$m^2$ |
| 8 | 14,000 cd/$m^2$ |
| 9 | 15,000 cd/$m^2$ |

The element showing an emitting light luminance of 10,000 cd/$m^2$ can be made practicable by the invention.

It can be understood from the above data that the organic EL elements according to the invention is higher in the emitting light luminance compared with the comparative elements.

The transparent conductive film superior in the gas barrier ability such as the steam barrier ability and the oxygen barrier ability and in the transparency, the method for producing the film with high efficiency and the organic EL element showing high emitting light luminance using the film can be provided by the invention.

## Claims

**1.** A transparent conductive film comprising a transparent plastic film, a gas barrier layer and a transparent conductive layer, wherein
a refractive index is controlled so that the refractive index continuously or stepwise decreases from a surface of the transparent conductive film having the transparent conductive layer to the other surface of the transparent conductive film.

**2.** The transparent conductive film of claim 1, wherein
the gas barrier layer and the transparent conductive layer are provided in that order on one surface of the transparent plastic film; and
the refractive index in the gas barrier layer is controlled so that the refractive index continuously or stepwise decreases from a surface being in contact with the transparent conductive layer to a surface being in contact with the transparent plastic film.

**3.** The transparent conductive film of claim 1, wherein
the transparent conductive layer is provided on one surface of the transparent plastic film;
the gas barrier layer is provided on the other surface of the transparent plastic film; and
the refractive index in the gas barrier layer is smaller than the refractive index in the transparent plastic film.

**4.** The transparent conductive film of claim 1, wherein
the gas barrier layer comprises at least two metal elements.

**5.** A transparent conductive film comprising a transparent plastic film, gas barrier layer A, gas barrier layer B and a transparent conductive layer, wherein
gas barrier layer A and the transparent conductive layer are provided in that order on one surface of the transparent

plastic film;
gas barrier layer B is provided on the other surface of the transparent plastic film; and
Inequation (1) is satisfied, provided that a refractive index in the transparent conductive layer is designated as n1, a refractive index in gas barrier layer A is designated as n2, a refractive index in the transparent plastic film is designated as n3 and a refractive index in gas barrier layer B is designated as n4.

Inequation (1)

$$n1 \geq n2 \geq n3 \geq n4$$

wherein n1 > n4.

6. The transparent conductive film of claim 5, wherein
gas barrier layer A or gas barrier layer B comprises at least two metal elements.

7. The transparent conductive film of claim 1, wherein
Tg (a glass transition temperature) of the transparent plastic film is 180°C or more.

8. The transparent conductive film of claim 1, wherein
the transparent plastic film comprises a cellulose ester.

9. A method to manufacture the transparent conductive film of claim 1, wherein
at least one of the layers selected from the group consisting of the gas barrier layer, gas barrier layer A and the gas barrier layer is formed by means of a plasma CVD method.

10. The method of claim 9, wherein
the plasma CVD method is carried out under an ambient pressure or under a near ambient pressure.

11. The method of claim 9, wherein
the plasma CVD method comprises a film forming process in which a high frequency voltage in the range of 10 kHz to 2500 MHz is applied and an electric power in the range of 1 W/cm$^2$ to 50 W/cm$^2$ is supplied.

12. The method of claim 11, wherein
the high frequency voltage is obtained by superimposing an alternating voltage of a frequency range of 1 kHz to 1 MHz and an alternating voltage of a frequency range of 1 MHz to 2500 MHz.

13. An organic electroluminescent element comprising the transparent conductive film of claim 1 having thereon organic electroluminescent element constituting layers.

14. The transparent conductive film of claim 5, wherein
Tg (a glass transition temperature) of the transparent plastic film is 180°C or more.

15. The transparent conductive film of claim 5, wherein
the transparent plastic film comprises a cellulose ester.

16. A method to manufacture the transparent conductive film of claim 5, wherein
at least one of the layers selected from the group consisting of the gas barrier layer, gas barrier layer A and the gas barrier layer is formed by means of a plasma CVD method.

17. An organic electroluminescent element comprising the transparent conductive film of claim 5 having thereon organic electroluminescent element constituting layers.

FIG. 1

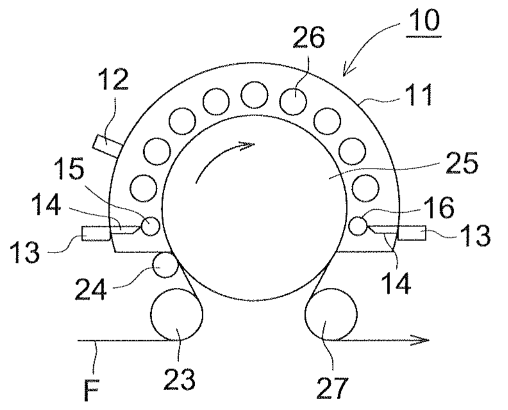


FIG. 2 ( a )

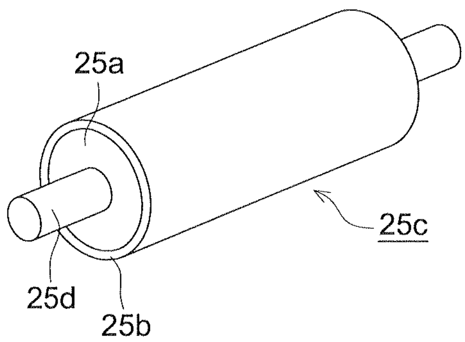


FIG. 2 ( b )

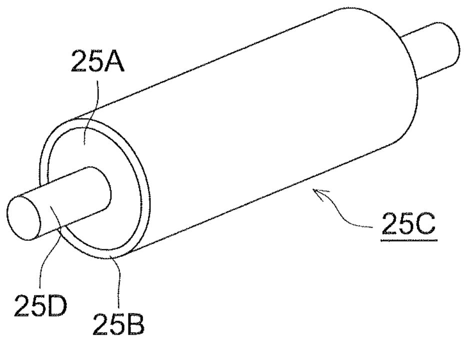

FIG. 3 (a)

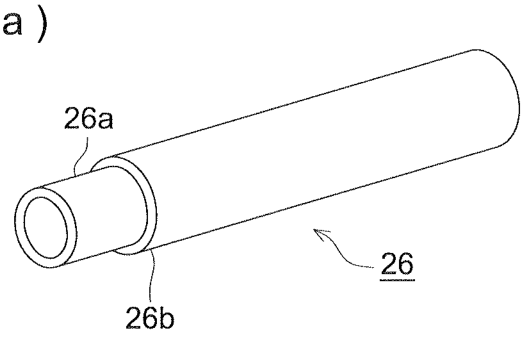


FIG. 3 (b)

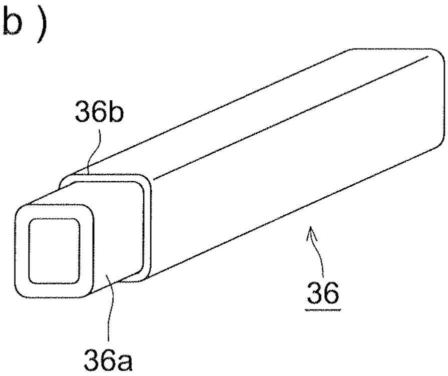


FIG. 4

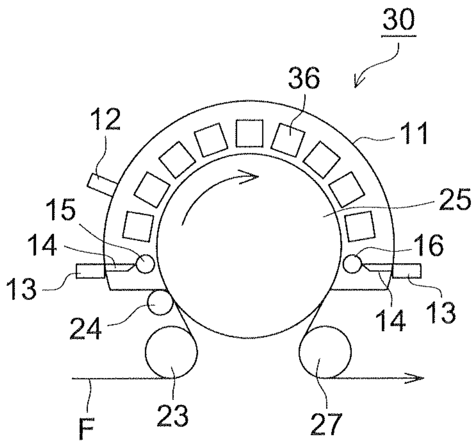

FIG. 5

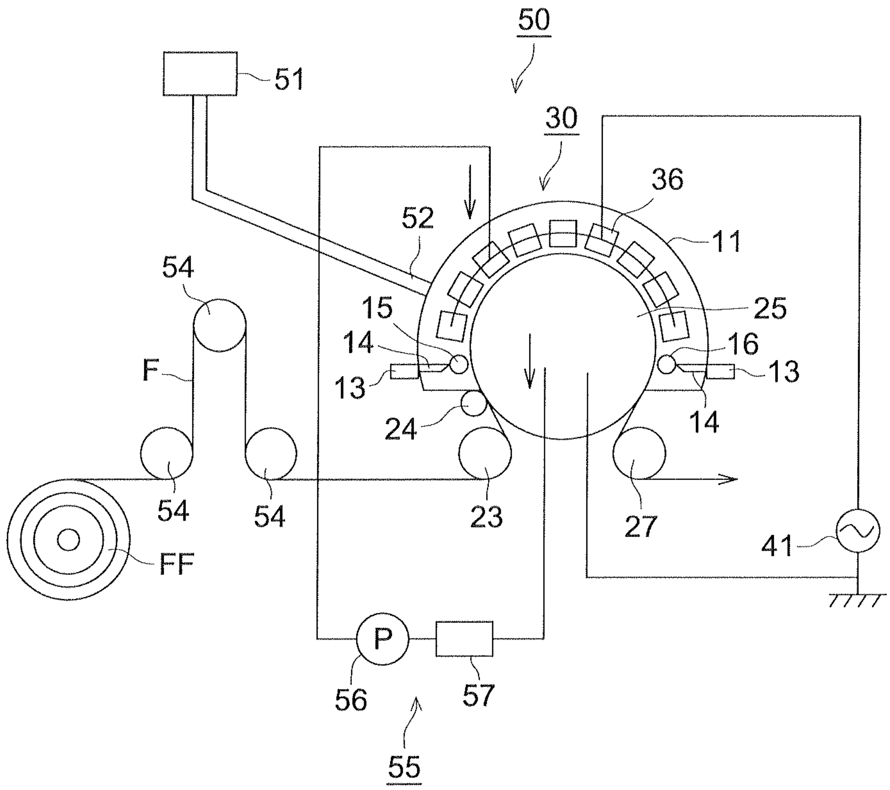
50
51
30
36
52
11
54
15
25
14
16
F
13
13
24
14
54
54
23
27
41
FF
P
56
57
55

FIG. 6

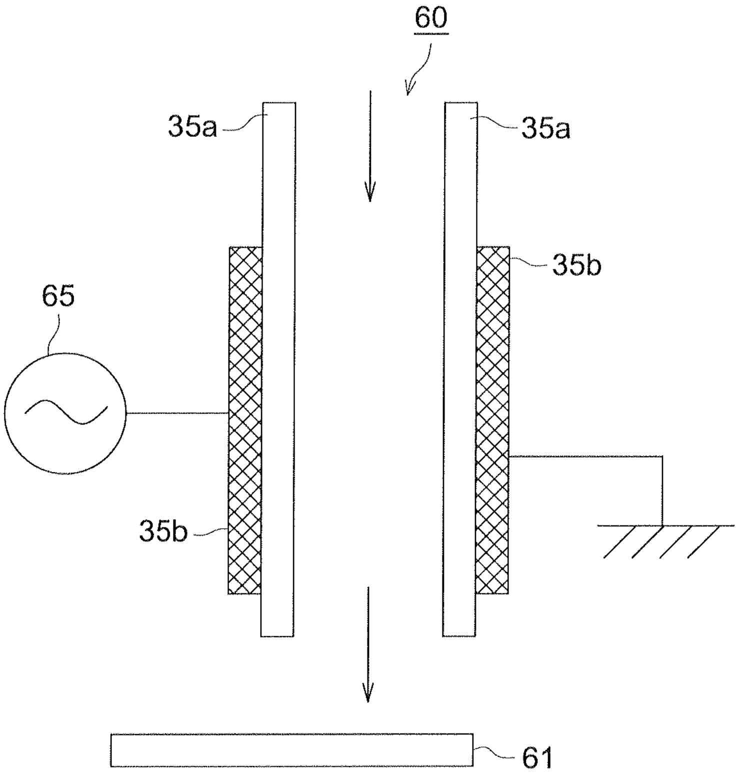


FIG. 7

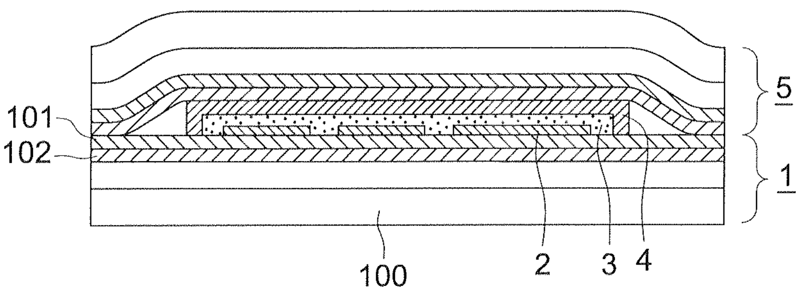

FIG. 8

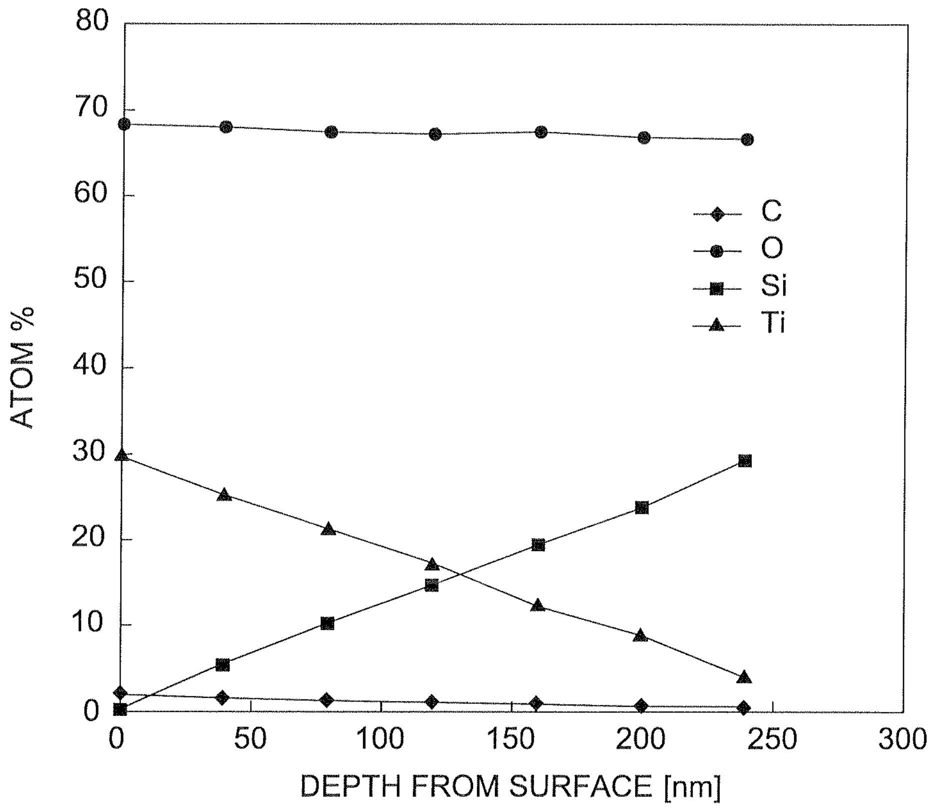
80
70
60
50
40
30
20
10
0
ATOM %
0
50
100
150
200
250
300
DEPTH FROM SURFACE [nm]
C
O
Si
Ti

## INTERNATIONAL SEARCH REPORT

International application No.
PCT/JP2005/004680

A. CLASSIFICATION OF SUBJECT MATTER
Int.Cl[7] B32B7/02, C08J7/06, G09F9/30, H05B33/02, 33/04, 33/14// C23C16/40, 16/42

According to International Patent Classification (IPC) or to both national classification and IPC

B. FIELDS SEARCHED

Minimum documentation searched (classification system followed by classification symbols)
Int.Cl[7] B32B7/02, C08J7/06, G09F9/30, H05B33/02, 33/04, 33/14// C23C16/40, 16/42

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2003-303520 A (Konica Minolta Holdings Kabushiki Kaisha), 24 October, 2003 (24.10.03), Claims (Family: none) | 1-17 |
| A | JP 10-309770 A (Mitsubishi Chemical Corp.), 24 November, 1998 (24.11.98), Claims (Family: none) | 1-17 |
| A | JP 2002-277608 A (Sony Corp.), 25 September, 2002 (25.09.02), Claims; Fig. 1 (Family: none) | 1-17 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 29 June, 2005 (29.06.05) | 19 July, 2005 (19.07.05) |
| Name and mailing address of the ISA/ Japanese Patent Office | Authorized officer |
| Facsimile No. | Telephone No. |

Form PCT/ISA/210 (second sheet) (January 2004)

INTERNATIONAL SEARCH REPORT

International application No.
PCT/JP2005/004680

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-338307 A (Dainippon Printing Co., Ltd.), 08 December, 2000 (08.12.00), Claims; Figs. 1, 2 (Family: none) | 1-17 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0036665 A
- JP 5299519 A
- JP 2002040205 A
- JP 11198281 A
- JP 2000192246 A
- WO 0070656 A
- JP 2001313178 A
- JP 2001247859 A
- WO 0070655 A
- JP 57051781 A
- US 5061569 A
- JP 308688 A
- JP 59194393 A
- JP 9045479 A
- JP 9260062 A
- JP 8288069 A
- JP 6325871 A
- JP 9017574 A
- JP 10074586 A
- JP 11204258 A
- JP 11204359 A


### Non-patent literature cited in the description


- **D. A. SHIRLEY.** *Phys. Rev.., B,* 1972, vol. 5, 4709
- *Macromol. Symp.,* vol. 125, 17-26
- Electrode Material. Organic EL element and Front of Its Industrialization. NTS Co., Ltd, 30 November 1998, 123-166
- Organic EL element and Front of Its Industrialization. NTS Co., Ltd, 30 November 1998, 237